# EUROPEAN PATENT APPLICATION

(11) **EP 4 756 811 A1**
(43) Date of publication of application: **10.06.2026**
(21) Application number: 25220731.1
(22) Date of filing: 04.12.2025
(51) Int. Cl.: G11C 16/10, G11C 16/30, G11C 16/04, G11C 16/32

(54) **STORAGE DEVICE WHICH SUPPORTS PLANE-INDEPENDENT SUSPEND COMMAND AND RESUME COMMAND AND METHOD OF OPERATING THE SAME**

(30) Priority: 06.12.2024 KR 20240180776; 22.10.2025 US 202519365895
(71) Applicant: Samsung Electronics Co., Ltd., Suwon-si, Gyeonggi-do 16677 (KR)
(72) Inventor: HONG, Jinwoo, 16677 Suwon-si (KR); CHOI, Junchul, 16677 Suwon-si (KR); KIM, Insoo, 16677 Suwon-si (KR)
(74) Representative: Marks & Clerk LLP

(57) **Abstract**

A storage device (1000) includes a nonvolatile memory device (1200) and a storage controller (1100) controlling the nonvolatile memory device (1200). The nonvolatile memory (NVM11) includes a plurality of planes (PL1, PL2). The storage controller (1100) performs a write operation on each of a first plane (PL1) and a second plane (PL2) among the plurality of planes (PL1, PL2) in response to a write request from a host device (100), and generates a suspend command for temporarily suspending the write operation on the first plane (PL1) in response to a read request from the host device (100) while the write operations on the first plane (PL1) and the second plane (PL2) are performed.

## Description

### BACKGROUND

A semiconductor memory is classified as a volatile memory device, which loses data stored therein when a power is turned off, such as a static RAM (SRAM) or a dynamic RAM (DRAM) or a non-volatile memory device, which retains data stored therein even when a power is turned off, such as a flash memory, a phase-change RAM (PRAM), a magnetic RAM (MRAM), a resistive RAM (RRAM), or a ferroelectric RAM (FRAM).

Meanwhile, a storage device such as a solid state drive (SSD) includes a nonvolatile memory device such as a flash memory to store data semi-permanently. The nonvolatile memory device includes a plurality of channels, and a plurality of nonvolatile memories are connected to each channel to communicate with a controller. One nonvolatile memory device includes a plurality of planes.

However, a nonvolatile memory may not provide a function of temporarily suspending a program operation, a read operation, or an erase operation for each plane or resuming the suspended operation for each plane. Accordingly, when there are performed a plurality of mixed operations on one nonvolatile memory, all operations which are being performed in another plane are also suspended to perform a specific operation in one plane. This causes an increase in a meaningless idle time of the storage device, thereby hindering the performance of the storage device.

### SUMMARY

Some aspects of the present disclosure provide methods of individually or independently suspending operations being performed in planes of a nonvolatile memory.

Some aspects of the present disclosure provide methods of individually or independently resuming operations on planes of a nonvolatile memory.

There is discloses, a storage device including a nonvolatile memory device including a nonvolatile memory including a plurality of planes, and a storage controller controlling the nonvolatile memory device. The storage controller performs a write operation on each of a first plane and a second plane among the plurality of planes in response to a write request from a host device, and generates a suspend command for temporarily suspending the write operation on the first plane in response to a read request from the host device while the write operations on the first plane and the second plane are performed.

According to some implementations, a storage device may include a nonvolatile memory device including a nonvolatile memory including a plurality of planes, and a storage controller controlling the nonvolatile memory device. While a first operation on each of a first plane and a second plane of the nonvolatile memory is performed, the storage controller generates a suspend command for temporarily suspending the first operation on the first plane.

According to some implementations, a method of operating a storage device which includes a nonvolatile memory device including a nonvolatile memory including a plurality of planes and a storage controller controlling the nonvolatile memory device may include performing a first operation on each of a first plane and a second plane among the plurality of planes, receiving a request from a host device, generating a suspend command for temporarily suspending the first operation on the first plane while the first operation on the first plane and the first operation on the second plane are performed, and temporarily suspending the first operation on the first plane in response to the suspend command.
At least some of the above and other features of the invention are set out in the claims.

### BRIEF DESCRIPTION OF THE DRAWINGS

The above and other objects and features of the present disclosure will become apparent by describing in detail examples thereof with reference to the accompanying drawings.
FIG. 1 is a block diagram of an example of a storage system.
FIG. 2 is a diagram illustrating an example of a software architecture of a storage system.
FIG. 3 is a diagram illustrating an example of a configuration of a storage controller.
FIG. 4 is a diagram illustrating an example of a nonvolatile memory device.
FIG. 5 is a diagram illustrating an example of a configuration of a nonvolatile memory device.
FIG. 6 is a diagram illustrating an example of a memory block of a plane.
FIG. 7 is a flowchart illustrating an example of an operating method of a storage device.
FIGS. 8A and 8B are diagrams illustrating an example of a configuration of a voltage generator of a peripheral circuit.
FIG. 9 is a diagram illustrating an example of an operating method of a storage device.
FIG. 10 is a timing diagram illustrating examples of a write operation and a read operation.
FIG. 11 is a timing diagram illustrating examples of a write operation and a read operation.
FIG. 12 is a flowchart illustrating an example of an operating method of a storage device.
FIG. 13 is a diagram illustrating an example of an operating method of a storage device as described with reference to FIG. 12.
FIG. 14 is a timing diagram illustrating examples of a physical erase operation and a read operation.
FIG. 15 is a flowchart illustrating an example of an operating method of a storage device.
FIG. 16 is a diagram illustrating an example of an operating method of a storage device as described with reference to FIG. 15.
FIG. 17 is a timing diagram illustrating examples of a physical erase operation and a write operation.
FIG. 18 is a diagram illustrating an example of a configuration of a storage controller.
FIG. 19 is a flowchart illustrating an example of an operating method of a storage device.
FIG. 20 is a flowchart illustrating an example of an operating method of a storage device.
FIG. 21 is a diagram illustrating an example of a memory device.

### DETAILED DESCRIPTION

In the detailed description, components which are described using the terms "unit", "module", "block", "~er or ~or", etc. and function blocks which are illustrated in drawings, may be implemented in the form of software or hardware or a combination thereof. For example, the software may include a machine code, firmware, an embedded code, and application software. For example, the hardware may include an electrical circuit, an electronic circuit, a processor, a computer, an integrated circuit, integrated circuit cores, a pressure sensor, an inertial sensor, a microelectromechanical system (MEMS), a passive element, or a combination thereof.

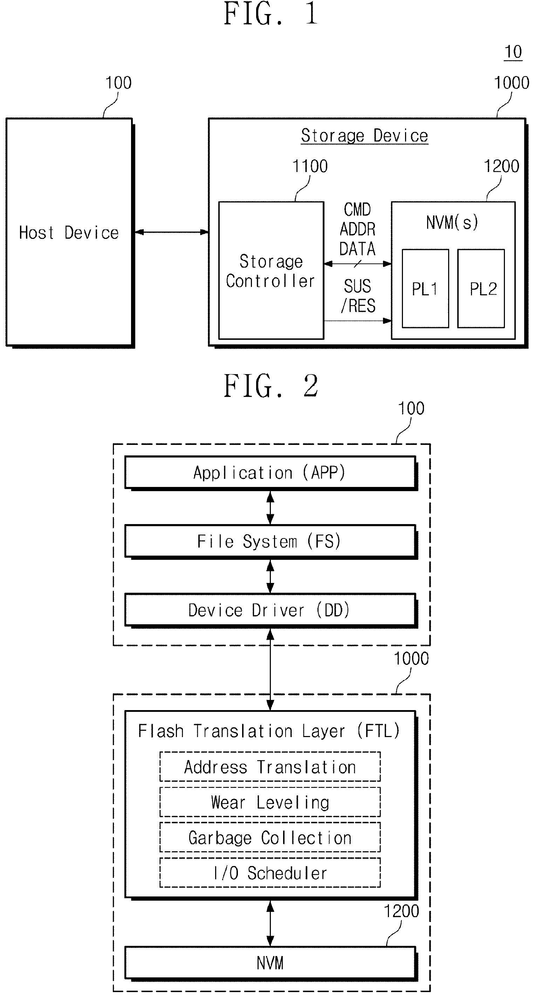

FIG. 1 is a block diagram of an example of a storage system. Referring to FIG. 1, a storage system 10 may include a host device 100 and a storage device 1000. In some implementations, the storage system 10 may be implemented with a computing system, which is configured to process a variety of information, such as a personal computer (PC), a notebook, a laptop, a server, a workstation, a tablet PC, a smartphone, a digital camera, and/or a black box.

The host device 100 may store data in the storage device 1000 or may read data stored in the storage device 1000. For example, the host device 100 may transfer a write request and write data to the storage device 1000 to store data in the storage device 1000. The host device 100 may provide the storage device 1000 with a read request for reading data stored in the storage device 1000 and may receive the data from the storage device 1000.

The storage device 1000 may include a storage controller 1100 and a nonvolatile memory device 1200. The storage controller 1100 may operate in response to a request received from the host device 100. For example, the storage controller 1100 may receive a write request and write data from the host device 100 and may store write data in the nonvolatile memory device 1200 in response to the write request. The storage controller 1100 may receive the read request from the host device 100 and may read data stored in the nonvolatile memory device 1200 in response to the read request. Afterwards, the storage controller 1100 may transfer the read data to the host device 100.

In some implementations, the storage controller 1100 may operate in response to a plurality of requests received from the host device 100. For example, when a second request is received from the host device 100 while the storage controller 1100 processes a first request received from the host device 100, the storage controller 1100 may generate a suspend command SUS for temporarily suspending an operation being performed on the nonvolatile memory device 1200 and may transfer the suspend command SUS to the nonvolatile memory device 1200.

A suspend command may be applied to all planes (e.g., PL1 and PL2) constituting (e.g., included in) one nonvolatile memory device. However, according to some implementations of the present disclosure, the suspend command SUS can be independently applied to each plane constituting one nonvolatile memory device, e.g., independently or separately. In this case, even though an operation (e.g., a read operation or a write operation) according to the first request is being performed in a plurality of planes PL1 and PL2, the operation according to the first request can be temporarily suspended only in the first plane PL1. Also, an operation according to the second request can be performed in the first plane PL1 while the operation according to the first request is being performed in the second plane PL2. When the operation according to the second request for the first plane PL1 is completed, the storage controller 1100 may transfer a resume command RES to the first plane PL1 such that the operation according to the first request for the first plane PL1 is resumed.

In some implementations, the nonvolatile memory device 1200 may include a NAND flash memory device. For example, each memory cell of the planes PL1 and PL2 may be implemented with at least one of a single level cell (SLC) storing one bit, a multi-level cell (MLC) storing two bits, a triple level cell (TLC) storing three bits, a quadruple level cell (QLC) storing four bits, or a cell storing five or more bits.

FIG. 2 shows a software architecture of a storage system, e.g., the storage system of FIG. 1.

Referring to FIGS. 1 and 2, the software architecture of the storage system 10 may include an application APP, a file system FS, a device driver DD, and a flash translation layer FTL.

The application APP may include various application programs which are driven by an operating system (OS) of the host device 100. For example, the application APP include various programs, which are driven on the host device 100, such as a document editor, a web browser, a spreadsheet, a voice player, or an image player.

The file system FS may be configured to organize files or data which are used by the application APP. For example, the file system FS may manage the storage space of the storage device 1000 by using a logical block address (LBA). The file system FS may assign and manage the logical block address to data to be stored in the storage device 1000. In some implementations, the type of the file system FS may change depending on the operating system of the host device 100. The file system FS may include at least one of various file systems such as an FAT (File Allocation Table), an FAT32, an NTFS (NT File System), an HFS (Hierarchical File System), a JSF2 (Journaled File System2), an XFS, an ODS-5 (On-Disk Structure-5), an UDF, a ZFS, an UFS (Unix File System), an ext2, an ext3, an ext4, an ReiserFS, an Reiser4, an ISO 9660, a Gnome VFS, a BFS, and a WinFS.

The device driver DD may control devices included in the host device 100 and/or devices connected to the host device 100. The device driver DD may convert information from the file system FS or the application APP into information capable of being recognized by the storage device 1000. In some implementations, the application APP, the file system FS, and the device driver DD may be implemented in the form of software and may be driven on the host device 100.

The flash translation layer FTL may translate a logical block address (or a logical address) of a request received from the host device 100 into a physical block address (or a physical address) to be used in the nonvolatile memory device 1200. In addition, the flash translation layer FTL may perform operations including the following operations on the nonvolatile memory device 1200: garbage collection, wear leveling, I/O scheduling, etc. For example, when a plurality of requests are received from the host device 100, the flash translation layer FTL may schedule the execution of the requests depending on a policy. For example, the flash translation layer FTL may determine whether to temporarily suspend an operation being already performed on the nonvolatile memory device 1200 or whether to resume the suspended operation.

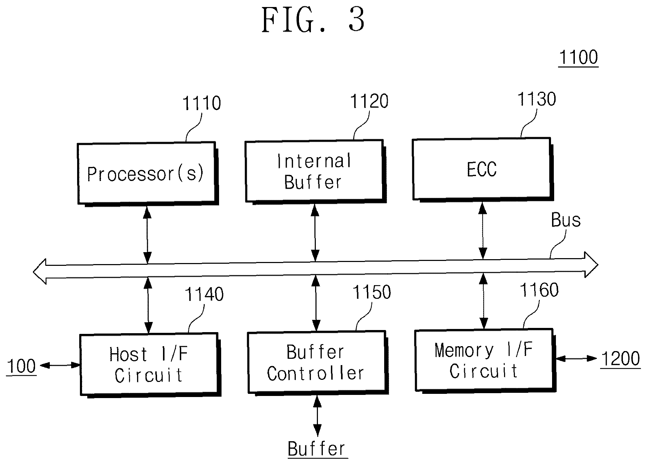

FIG. 3 illustrates an example of a configuration of a storage controller, e.g., the storage controller of FIG. 1.

The storage controller 1100 includes at least one processor 1110, an internal buffer 1120, an error check and correction (ECC) engine 1130, a host interface circuit 1140, a buffer controller 1150, and a memory interface circuit 1160.

The processor 1110 controls overall operations (e.g., all operations) of the storage controller 1100. The processor 1110 may drive various operating systems, firmware, software, etc. necessary to control the nonvolatile memory device 1200. For example, the processor 1110 may drive a flash translation layer for managing a mapping table in which a relationship between logical addresses of the host device 100 and physical addresses of the nonvolatile memory device 1200 is defined.

The processor 1110 may store requests received from the host device 100 in the internal buffer 1120. The processor 1110 may generate addresses and commands for controlling the nonvolatile memory device 1200, based on the received requests. The processor 1110 may store various data for managing the storage device 1000 in the internal buffer 1120. For example, the internal buffer 1120 may include a static random access memory (SRAM) and/or a dynamic random access memory (DRAM).

The ECC engine 1130 may generate an error correction code ECC for write data to be stored in the nonvolatile memory device 1200 and may perform error correction encoding by using the error correction code ECC. The ECC engine 1130 may perform error correction decoding for read data by using the error correction code ECC read from the nonvolatile memory device 1200.

The host interface circuit 1140 may communicate with the host device 100 by using a bus having various communication protocols. For example, the bus format may include one or more of various interface protocols such as USB, small computer system interface (SCSI), peripheral component interconnect express (PCIe), mobile PCIe (M-PCIe), advanced technology attachment (ATA), parallel ATA (PATA), serial ATA (SATA), serial attached SCSI (SAS), integrated drive electronics (IDE), enhanced IDE (EIDE), non-volatile memory express (NVMe), and universal flash storage (UFS).

The buffer controller 1150 may provide interfacing between the storage controller 1100 and a buffer (e.g., a random access memory (RAM)). The buffer controller 1150 may access the buffer depending on a request of the processor 1110 or any other intellectual property (IP). For example, under control of the processor 1110, the buffer controller 1150 may temporarily record the write data to be stored in the nonvolatile memory device 1200 and/or the read data read from the nonvolatile memory device 1200 at the buffer.

The memory interface circuit 1160 may communicate with the nonvolatile memory device 1200. For example, the memory interface circuit 1160 may access the nonvolatile memory device 1200 through various signal lines. The memory interface circuit 1160 may communicate with the nonvolatile memory device 1200, based on a protocol defined in compliance with the standard or defined by a manufacturer.

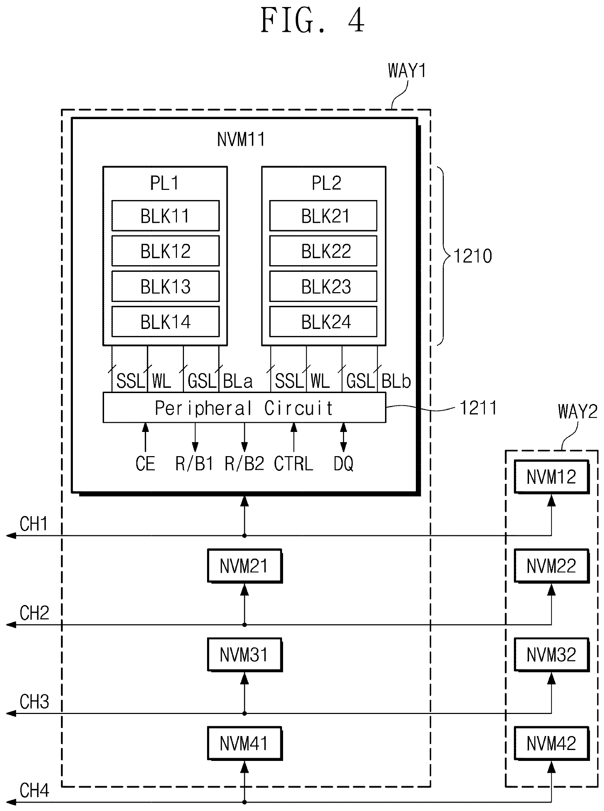

FIG. 4 illustrates an example of a nonvolatile memory device, e.g., the nonvolatile memory device 1200 of FIG. 1.

Referring to FIGS. 1 and 4, the nonvolatile memory device 1200 may include a plurality of nonvolatile memories NVM11 to NVM42. Each of the plurality of nonvolatile memories NVM11 to NVM42 may be implemented with one semiconductor chip, one semiconductor die, or one semiconductor package.

The nonvolatile memory NVM11 may include a memory cell array 1210 and a peripheral circuit 1211, and the memory cell array 1210 may include the plurality of planes PL1 and PL2. The nonvolatile memory NVM11 including two planes is illustrated, but the number of planes is not limited thereto. For example, the nonvolatile memory NVM11 may include four, eight, or more planes. The plane PL1 may include a plurality of memory blocks BLK11 to BLK14, and the plane PL2 may include a plurality of memory blocks BLK21 to BLK24. Each of the plurality of memory blocks BLK11 to BLK14 and BLK21 to BLK24 may include a plurality of pages. In some implementations, a plurality of memory blocks (e.g., BLK11 to BLK14) included in one plane (e.g., PL1) may be configured to share the same bit lines, but the scope of the present disclosure is not limited thereto.

The memory cell array 1210 may be connected to the peripheral circuit 1211 through word lines WL, string selection lines SSL, ground selection lines GSL, and bit lines BLa and BLb. Each of the planes PL1 and PL2 includes a plurality of memory blocks. Each of the plurality of memory blocks may include a plurality of memory cells, which are connected to the plurality of word lines WL.

In some implementations, the plurality of memory blocks included in the first plane PL1 may share the bit lines BLa. The plurality of memory blocks included in the second plane PL2 may share the bit lines BLb different from the bit lines BLa. That is, the first plane PL1 and the second plane PL2 may be distinguished from each other by bit lines.

The peripheral circuit 1211 may receive a chip enable signal CE, a control signal CTRL, and a data signal DQ from the storage controller 1100. The peripheral circuit 1211 may program data received through the data signal DQ in the memory cell array 1210 in response to the received signals, or in response to the received signals, the peripheral circuit 1211 may read data programmed in the memory cell array 1210 and may transfer the read data to the storage controller 1100 through the data signal DQ.

In some implementations, the peripheral circuit 1211 may activate the ready/busy signal independently for each plane, depending on whether a plane operates. For example, the peripheral circuit 1211 may activate a first ready/busy signal R/B1 while the first plane PL1 is operating and may activate a second ready/busy signal R/B2 while the second plane PL2 is operating. In some implementations, when the first ready/busy signal R/B1 is activated, the storage controller 1100 may be incapable of transferring a separate command and/or a separate address to the first plane PL1; when the second ready/busy signal R/B2 is activated, the storage controller 1100 may be incapable of transferring a separate command and/or a separate address to the second plane PL2.

In some implementations, the control signal CTRL may include a command latch enable signal (CLE), an address latch enable signal (ALE), a write enable signal (WEB), a read enable signal (REB), a data strobe signal DQS. Information included in the data signal DQ may be classified as a command, an address, or data depending on the control signal CTRL.

The peripheral circuit 1211 of the nonvolatile memory NVM11 may be connected to one channel (e.g., CH1) among a plurality of channels CH1 to CH4. In response to various signals received through the first channel CH1, the peripheral circuit 1211 may store data received through the first channel CH1 in the plurality of planes PL1 and PL2 or may output data stored in the plurality of planes PL1 and PL2 through the first channel CH1. For the above operations, the peripheral circuit 1211 may include various components such as an address decoder, a voltage generator, a page buffer circuit, an input/output circuit, and a control logic circuit.

For clarity of drawing, an example in which one nonvolatile memory NVM11 includes two planes PL1 and PL2 and one plane includes four memory blocks is illustrated, but the scope of the present disclosure is not limited thereto. For example, the number of planes, the number of memory blocks, and/or the number of pages may be variously changed and modified. The nonvolatile memories NVM12 to NVM42 may be similar in structure to the nonvolatile memory NVM11, and thus, additional description will be omitted to avoid redundancy.

In the plurality of nonvolatile memories NVM11 to NVM42, a first part of nonvolatile memories NVM11 and NVM12 may communicate with the storage controller 1100 through the first channel CH1, a second part of nonvolatile memories NVM21 and NVM22 may communicate with the storage controller 1100 through the second channel CH2, a third part of nonvolatile memories NVM31 and NVM32 may communicate with the storage controller 1100 through the third channel CH3, and a fourth part of nonvolatile memories NVM41 and NVM42 may communicate with the storage controller 1100 through the fourth channel CH4.

In the plurality of nonvolatile memories NVM11 to NVM42, a fifth part of nonvolatile memories NVM11, NVM21, NVM31, and NVM41 may constitute a first way WAY1, and a sixth part of nonvolatile memories NVM12, NVM22, NVM32, and NVM42 may constitute a second way WAY2. That is, the nonvolatile memory device 1200 may have a multi-way/multi-channel structure, and it will be understood that the connections of the nonvolatile memory device 1200 are not limited to the structure illustrated in FIG. 4.

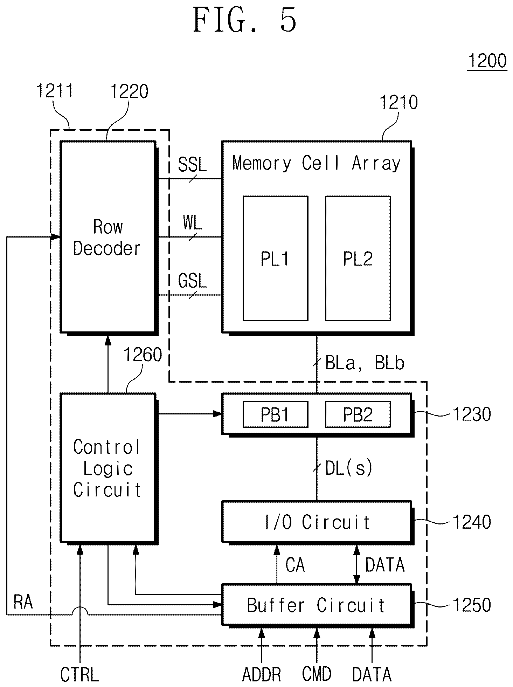

FIG. 5 illustrates an example of a configuration of a nonvolatile memory device, e.g., the nonvolatile memory device 1200 of FIG. 1.

Referring to FIG. 5, the nonvolatile memory device 1200 may include the memory cell array 1210, a row decoder 1220, a page buffer circuit 1230, an input/output circuit 1240, a buffer circuit 1250, and a control logic circuit 1260.

The memory cell array 1210 may include the plurality of planes PL1 and PL2. Each of the planes PL1 and PL2 may include a plurality of memory blocks, and each of the memory blocks may include a plurality of memory cells. Each of the memory blocks may be connected to the row decoder 1220 through at least one ground selection line GSL, the word lines WL, and at least one string selection line SSL. Some of the word lines WL may be used as dummy word lines. The memory blocks of the first plane PL1 may be connected to a first page buffer PB1 of the page buffer circuit 1230 through the plurality of bit lines BLa. The memory blocks of the second plane PL2 may be connected to a second page buffer PB2 of the page buffer circuit 1230 through the plurality of bit lines BLb.

In some implementations, each of the plurality of memory blocks may correspond to a unit of the erase operation. Memory cells belonging to each memory block may be erased at the same time. As another example, each memory block may be divided into a plurality of sub-blocks. Each of the plurality of sub-blocks may correspond to a unit of the erase operation.

The row decoder 1220 may be connected to the memory cell array 1210 through the ground selection lines GSL, the word lines WL, and the string selection lines SSL. The row decoder 1220 operates under control of the control logic circuit 1260. The row decoder 1220 may decode a row address RA received from the buffer circuit 1250 and may control voltages to be applied to the string selection lines SSL, the word lines WL, and the ground selection lines GSL based on the decoded row address.

The page buffer circuit 1230 may be connected to the planes PL1 and PL2 through the plurality of bit lines BLa and BLb. The page buffer circuit 1230 may be connected to the input/output circuit 1240 through a plurality of data lines DL. The page buffer circuit 1230 operates under control of the control logic circuit 1260.

In the write operation, the page buffer circuit 1230 may store data to be written in memory cells. The page buffer circuit 1230 may apply voltages to the plurality of bit lines BLa and BLb based on the stored data. In the read operation or in the verify read operation which performed in the write operation or the erase operation, the page buffer circuit 1230 may sense voltages of the bit lines BLa and BLb and may store a result of the sensing.

The input/output circuit 1240 may be connected to the page buffer circuit 1230 through the plurality of data lines DL. The input/output circuit 1240 may receive a column address CA from the buffer circuit 1250. The input/output circuit 1240 may output the data read by the page buffer circuit 1230 to the buffer circuit 1250 depending on the column address CA. The input/output circuit 1240 may transfer the data received from the buffer circuit 1250 to the page buffer circuit 1230, depending the column address CA.

The buffer circuit 1250 may receive a command CMD and an address ADDR from the storage controller 1100 (refer to FIG. 1) and exchange data "DATA". The buffer circuit 1250 may operate under control of the control logic circuit 1260. The buffer circuit 1250 may transfer the command CMD to the control logic circuit 1260. The buffer circuit 1250 may transfer the row address RA of the address ADDR to the row decoder 1220 and may transfer the column address CA of the address ADDR to the input/output circuit 1240. The buffer circuit 1250 may exchange data "DATA" with the input/output circuit 1240.

The control logic circuit 1260 may receive the control signal CTRL from the storage controller 1100 (refer to FIG. 1). The control logic circuit 1260 may allow the buffer circuit 1250 to route the command CMD, the address ADDR, and the data "DATA".

The control logic circuit 1260 may decode the command CMD received from the buffer circuit 1250 and may control the nonvolatile memory device 1200 depending on the decoded command.

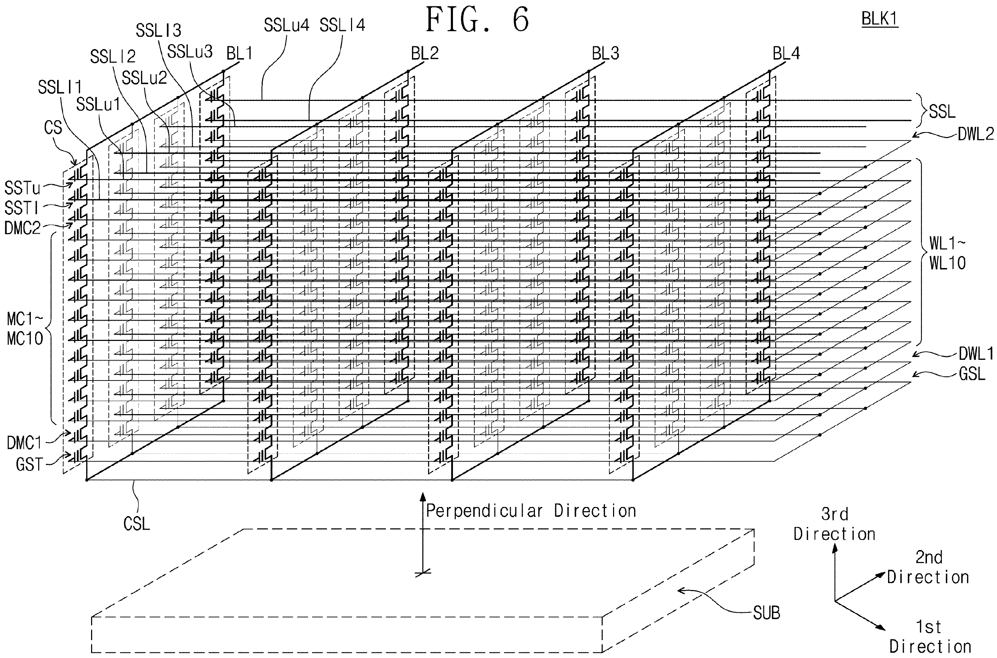

FIG. 6 illustrates an example of a memory block of a plane. Referring to FIG. 6, a plurality of cell strings CS may be arranged in rows and columns on a substrate SUB along a first direction, a second direction, and a third direction. The plurality of cell strings CS may be connected in common to a common source line CSL formed on (or in) the substrate SUB. In FIG. 6, a location of the substrate SUB is depicted as an example for better understanding of the structure of the memory block BLK1.

Cell strings of each row may be connected in common to the ground selection line GSL and may be connected to a corresponding string selection line among first to fourth upper string selection lines SSLu1 to SSLu4 and a corresponding string selection line among first to fourth lower string selection lines SSLl1 to SSLl4. Cell strings of each column may be connected to a corresponding bit line among first to fourth bit lines BL1 to BL4. To prevent a drawing from being complicated, cell strings connected to the second and third string selection lines SSL2l, SSL2u, SSL3l, and SSL3u are depicted to be blurred.

Each cell string may include at least one ground selection transistor GST connected to the ground selection line GSL, a first dummy memory cell DMC1 connected to a first dummy word line DWL1, first to tenth memory cells MC1 to MC10 respectively connected to first to tenth word lines WL1 to WL10, a second dummy memory cell DMC2 connected to a second dummy word line DWL2, and upper and lower string selection transistors SSTu and SSTl respectively connected to corresponding upper and lower string selection lines.

In each cell string CS, the ground selection transistor GST, the first dummy memory cell DMC1, the first to tenth memory cells MC1 to MC10, the second dummy memory cell DMC2, and the upper and lower string selection transistors SSTu and SSTl may be connected in series along the third direction being a perpendicular to the substrate SUB and may be sequentially stacked along the third direction being a perpendicular to the substrate SUB.

The memory block BLK1 is provided as a three-dimensional (3D) memory array. The 3D memory array is monolithically formed in one or more physical levels of arrays of memory cells MC having an active area disposed above a silicon substrate and a circuitry associated with the operation of those memory cells MC. The circuitry associated with the operation of the memory cells MC may be located on or within a substrate. The term "monolithic" means that layers of each level of the array are directly deposited on the layers of each underlying level of the 3D memory array.

As an example, the 3D memory array includes vertical cell strings CS (or NAND strings) which are vertically oriented such that at least one memory cell is located over another memory cell. The at least one memory cell may include a charge trap layer. Each cell string further includes at least one selection transistor placed on the memory cells MC. The at least one selection transistor may have the same structure as the memory cells MC and may be formed uniformly with the memory cells MC.

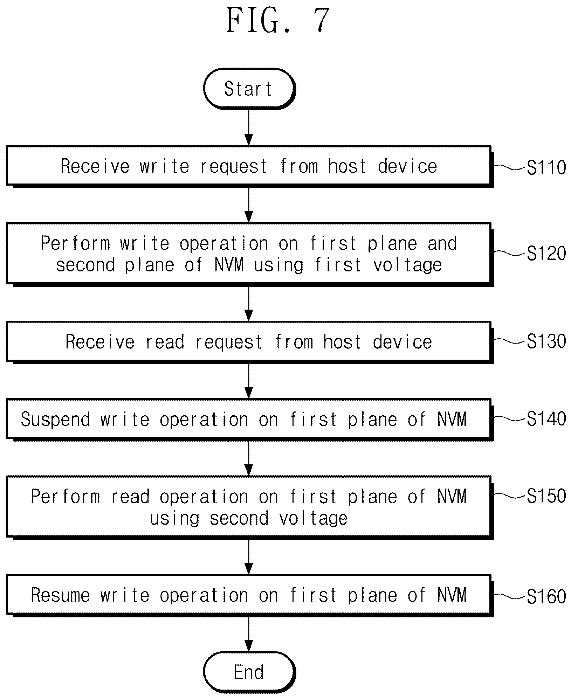

FIG. 7 is a flowchart illustrating an example of an operating method of a storage device. Referring to FIGS. 1, 4, and 7 together, in operation S110, the storage controller 1100 may receive the write request from the host device 100. The storage controller 1100 may generate a program command for storing data in the nonvolatile memory device 1200 in response to the write request.

In operation S120, the storage controller 1100 may simultaneously perform the write operations on the first plane PL1 and the second plane PL2 of the nonvolatile memory NVM11 based on the program command and the write data. For example, the program command described above may be a multi-plane program command. The storage controller 1100 may use a first voltage to perform the write operation. For example, the first voltage may be a program voltage. In addition to the program voltage, the storage controller 1100 may further use a verify voltage to perform the write operation. In some implementations, a voltage generator of the peripheral circuit 1211 may generate the program voltage, the verify voltage, etc. for performing the program operation.

In operation S130, the storage controller 1100 may receive the read request from the host device 100. The storage controller 1100 may generate a read command for reading data from the nonvolatile memory device 1200 in response to the read request.

In operation S140, the storage controller 1100 may temporarily suspend the write operation on a plane, on which the read operation will be performed depending on the read command, from among the planes PL1 and PL2 in which the write operations are being performed. In some implementations, the write operation being performed on the first plane PL1 or the second plane PL2 can be temporarily suspended as the read command is input to an input/output scheduler. The storage controller 1100 may generate a suspend command. The suspend command supports a suspend operation independently for each plane, e.g., as opposed to requiring that the suspend command be applied to all planes.

In operation S150, the storage controller 1100 may perform the read operations on the first plane PL1 of the nonvolatile memory NVM11 based on the read command. The storage controller 1100 may use a second voltage to perform the read operation. For example, the second voltage may be a read voltage.

Meanwhile, because the write operation is still being performed on the second plane PL2 while the read operation is being performed on the first plane PL1, the first plane PL1 and the second plane PL2 may operate based on different voltages. For example, the first plane PL1 may be provided with the second voltage (e.g., the read voltage) necessary or used for the read operation, and the second plane PL2 may be provided with the first voltage (e.g., the program voltage) necessary or used for the write operation.

To this end, the voltage generator of the peripheral circuit 1211 may be configured to simultaneously generate voltages of different levels. For example, the voltage generator of the peripheral circuit 1211 may include a plurality of voltage generators. As another example, the voltage generator of the peripheral circuit 1211 may include one charge pump and a regulator for adjusting a level of a voltage output from the charge pump. However, the configuration of the voltage generator of the peripheral circuit 1211 is not limited to the above examples. For example, the voltage generator of the peripheral circuit 1211 may be implemented with various different suitable components for simultaneously generating voltages of different levels.

In operation S160, when the read operation on the first plane PL1 ends, the storage controller 1100 may resume the write operation on the first plane PL1. The suspend command can support a resume operation independently for each plane, e.g., as opposed to requiring that a resume command be applied to all planes. For example, a resume command can be applied independently to a plane.

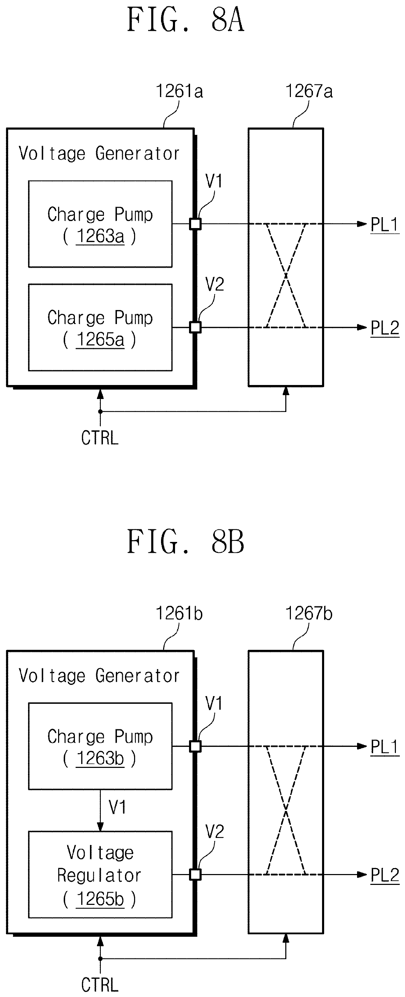

FIGS. 8A and 8B illustrate an example of a configuration of a voltage generator of a peripheral circuit, e.g., the peripheral circuit 1211 described with reference to FIGS. 5 and 7.

Here, a voltage generator is illustrated as a component of the control logic circuit 1260, but the present disclosure is not limited thereto. For example, the voltage generator may be implemented outside the control logic circuit 1260. That is, it should be understood that even though the voltage generator can be implemented inside or outside a control logic circuit, the voltage generator is a part of the peripheral circuit.

First, referring to FIG. 8A, a voltage generator 1261a may include a first charge pump 1263a and a second charge pump 1265a. The first charge pump 1263a and the second charge pump 1265a may operate in response to the control signal CTRL. The first charge pump 1263a and the second charge pump 1265a may be provided with a voltage from an external component (e.g., a Power Management Integrated Circuit (PMIC)) and may output a first voltage V1 and a second voltage V2, respectively. For example, the first voltage V1 may be the first voltage described with reference to FIG. 7, and the second voltage V2 may be the second voltage described with reference to FIG. 7.

The first voltage V1 and the second voltage V2 may be provided to the first plane PL1 and/or the second plane PL2 through a switching circuit 1267a. For example, depending on an operation of the switching circuit 1267a, the first voltage V1 for performing a first operation may be provided to the first plane PL1 and the second plane PL2. After the first operation on the first plane PL1 is temporarily suspended by the suspend command, the second voltage V2 for performing a second operation may be provided to the first plane PL1 depending on the operation of the switching circuit 1267a. Of course, the first voltage V1 for performing the first operation may be provided to the second plane PL2.

For clarity, a detailed configuration of the charge pumps 1263a and 1265a is not illustrated, but charge pumps with various suitable configurations for supplying a voltage of a stable level from an external power may be used. Further, while a detailed configuration of the switching circuit 1267a is not illustrated for clarity, it will be understood that a combination of various suitable elements capable of performing a switching operation, such as a transistor, may be adopted and included in the switching circuit 1267a.

Referring to FIG. 8B, a voltage generator 1261b may include a charge pump 1263b and a voltage regulator 1265b. The charge pump 1263b and the voltage regulator 1265b may operate in response to the control signal CTRL, and the charge pump 1263b may be provided with a voltage from an external component (e.g., a PMIC) and may output the first voltage V1. The voltage regulator 1265b may output the second voltage V2 whose level is different from that of the first voltage V1, based on the first voltage V1. For example, the voltage regulator 1265b can receive the first voltage V1 and generate the second voltage V2 from the first voltage V1. Herein, the first voltage V1 may be the first voltage described with reference to FIG. 7, and the second voltage V2 may be the second voltage described with reference to FIG. 7.

Depending on an operation of a switching circuit 1267b, the first voltage V1 for performing the first operation may be provided to the first plane PL1 and the second plane PL2. After the first operation on the first plane PL1 is temporarily suspended by the suspend command, depending on the operation of the switching circuit 1267b, the second voltage V2 for performing the second operation may be provided to the first plane PL1, and the first voltage V1 for performing the first operation may be provided to the second plane PL2.

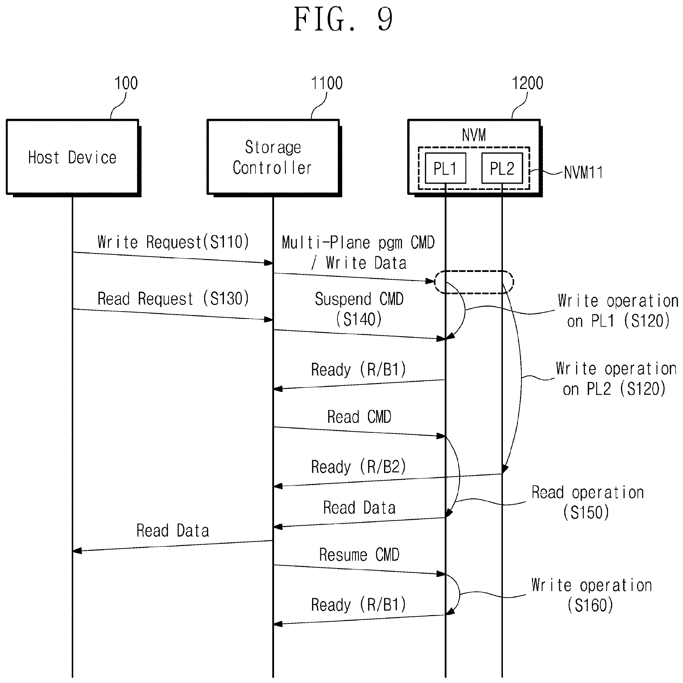

FIG. 9 is a diagram for describing an operating method of a storage device, e.g., the storage device described with reference to FIG. 7.

Referring to FIGS. 7 and 9, the host device 100 may transfer the write request to the storage controller 1100 according to a request of the user (S110), and the storage controller 1100 may generate the program command based on the write request. For example, the program command may be a command (i.e., a multi-plane program command) for the write operation associated with a multi-plane. The storage controller 1100 may transfer the multi-plane program command and the write data to the nonvolatile memory device 1200, and the nonvolatile memory NVM11 may perform the write operations on the first plane PL1 and the second plane PL2 (S120).

During the write operations on the first plane PL1 and the second plane PL2 of the nonvolatile memory NVM11, the host device 100 may transfer the read request to the storage controller 1100 according to the request of the user (S130). The storage controller 1100 may generate the read command based on the read request, and the input/output scheduler may schedule the write operation being already performed and the read operation to be performed, depending on a given policy.

When in a state in which the write operation being performed on the first plane PL1 is to be temporarily suspended as the read command is input to the input/output scheduler, the storage controller 1100 may generate the suspend command for suspending the operation being performed on the first plane PL1. In response to the suspend command, the write operation being performed on the first plane PL1 of the nonvolatile memory NVM11 may be temporarily suspended (S140). The nonvolatile memory NVM11 may deactivate the first ready/busy signal R/B1 to provide notification that the first plane PL1 is in a state where it is possible to perform an operation.

The storage controller 1100 may transfer the read command and the address to the nonvolatile memory NVM11 in response to the first ready/busy signal R/B1 thus deactivated. The nonvolatile memory NVM11 may perform the read operation on the first plane PL1 in response to the read command and the address (S150). Data read from the first plane PL1 as a result of the read operation may be transferred to the host device 100 through the storage controller 1100.

The storage controller 1100 may generate the resume command for the first plane PL1 and may transfer the resume command to the nonvolatile memory NVM11. In response to the resume command, the nonvolatile memory NVM11 may resume the write operation on the first plane PL1 (S160).

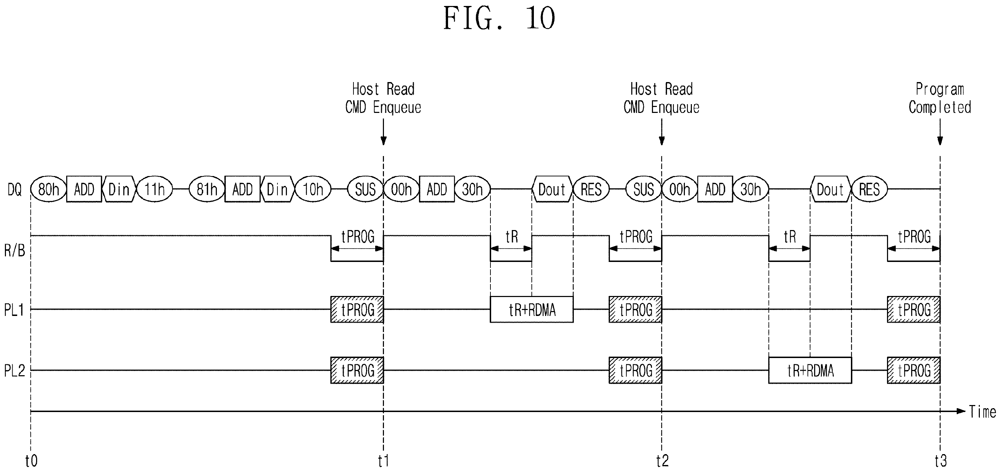

FIG. 10 is a timing diagram illustrating an example of a write operation and a read operation in detail, for a device in which suspend commands are provided jointly to multiple planes, e.g., as opposed to being provided independently per plane. The data signal DQ, the ready/busy signal R/B, and time values of operations which are performed in the first plane PL1 and the second plane PL2 are illustrated in FIG. 10. For convenience of description, it is assumed that the nonvolatile memory NVM11 (refer to FIG. 4) includes the first plane PL1 and the second plane PL2. Also, unlike some implementations described with respect to FIG. 4, for FIG. 10, it is assumed that the peripheral circuit 1211 outputs one ready/busy signal R/B. That is, the first plane PL1 and the second plane PL2 are simultaneously in a ready state or are simultaneously in a busy state. Also, it is assumed that the ready/busy signal R/B is a low enable signal which is activated at a logic low level.

Referring to FIGS. 1 and 10 together, at a time point t0, the storage controller 1100 may sequentially transfer commands, addresses, and data associated with a multi-plane write operation to the nonvolatile memory NVM11.

First, the storage controller 1100 activates the chip enable signal CE and transfers a first command 80h, an address ADD, write data Din, and a second command 11h to the nonvolatile memory NVM11 through the data signal DQ. Afterwards, the storage controller 1100 transfers a third command 81h, an address ADD, write data Din, and a fourth command 10h to the nonvolatile memory NVM11 through the data signal DQ.

In some implementations, the first command 80h is a command indicating a start of a page program for the first plane PL1 of the nonvolatile memory NVM11, the address ADD is an address indicating a physical location where the write data Din will be stored, and the second command 11h is a command which forms a set with the first command 80h and indicates an end of the transfer of a signal necessary for the page program for the first plane PL1 of the nonvolatile memory NVM11.

In some implementations, the third command 81h is a command indicating a start of a page program for the second plane PL2 of the nonvolatile memory NVM11, the address ADD is an address indicating a physical location where the write data Din will be stored, and the fourth command 10h is a command which forms a set with the third command 81h and indicates an end of the transfer of a signal necessary for the page program for the second plane PL2 of the nonvolatile memory NVM11.

When the fourth command 10h for the second plane PL2 is transferred to the nonvolatile memory NVM11, the write operation on the first plane PL1 and the write operation on the second plane PL2 may be performed during a program time tPROG.

Meanwhile, when the read request is enqueued to the input/output scheduler according to the read command from the host device 100 while the write operations are performed on the first plane PL1 and the second plane PL2, the program operation on the nonvolatile memory NVM11 should be suspended. Afterwards, the storage controller 1100 generates the suspend command SUS and transfers the suspend command SUS to the nonvolatile memory NVM11. At a time point t1, the nonvolatile memory NVM11 may temporarily suspend the write operations on the first plane PL1 and the second plane PL2 in response to the suspend command SUS. As described above, the reason is that this suspend command SUS is applied to all planes of one nonvolatile memory NVM11.

When both the write operation on the first plane PL1 and the write operation on the second plane PL2 are suspended by the suspend command SUS, the nonvolatile memory NVM11 may transfer, to the storage controller 1100, the ready/busy signal R/B indicating that all the planes of the nonvolatile memory NVM11 are in the ready state. In response to the ready/busy signal R/B, the storage controller 1100 transfers, to the nonvolatile memory NVM11, a first command 00h associated with the read operation, an address ADD, and a second command 30h associated with the read operation.

In some implementations, the first command 00h associated with the read operation is a command indicating a start of a page read, the address ADD is an address indicating a physical address where read data Dout are stored, and the second command 30h associated with the read operation is a command which forms a set with the first command 00h and indicates an end of the transfer of a signal necessary for the page read.

When the second command 30h associated with the read operation is transferred to the nonvolatile memory NVM11, the read operation on the first plane PL1 may be performed during a time "tR + RDMA". Herein, "tR" indicates a time during which data are transferred from a flash array to a register (e.g., a page buffer) (i.e., a data transfer from a flash array to a register), and "RDMA" indicates a time during which data are transferred from the register to the storage controller 1100. That is, during RDMA, the read data Dout may be transferred to the storage controller 1100. As illustrated in FIG. 9, it is understood that even though the read operation on the second plane PL2 is not performed, the write operation on the second plane PL2 is temporarily suspended.

When the read operation on the first plane PL1 ends, the nonvolatile memory NVM11 may transfer, to the storage controller 1100, the ready/busy signal R/B indicating that all the planes of the nonvolatile memory NVM11 are in the ready state. The storage controller 1100 generates the resume command RES for resuming the suspended write operation in response to the ready/busy signal R/B and transfers the resume command RES to the nonvolatile memory NVM11. In response to the resume command RES, the write operations on the first plane PL1 and the second plane PL2 in the nonvolatile memory NVM11 may be resumed. In some implementations, the write operations resumed in response to the resume command RES may be performed during tPROG.

Meanwhile, the read request for the nonvolatile memory NVM11 may be continuously issued. For example, after the write operations on the first plane PL1 and the second plane PL2 are resumed, the host device 100 may transfer the read request to the storage controller 1100, and the storage controller 1100 may transfer the suspend command SUS for temporarily suspending the write operations on the first plane PL1 and the second plane PL2 to the nonvolatile memory NVM11. At a time point t2, the storage controller 1100 may transfer the command set 00h and 30h and the address ADD according to the read request, and the read operation on the second plane PL2 may be performed during "tR + RDMA".

Afterwards, the write operations on the first plane PL1 and the second plane PL2 in the nonvolatile memory NVM11 may be resumed by the resume command RES, and at a time point t3, the write operations on the first plane PL1 and the second plane PL2 in the nonvolatile memory NVM11 may be completed.

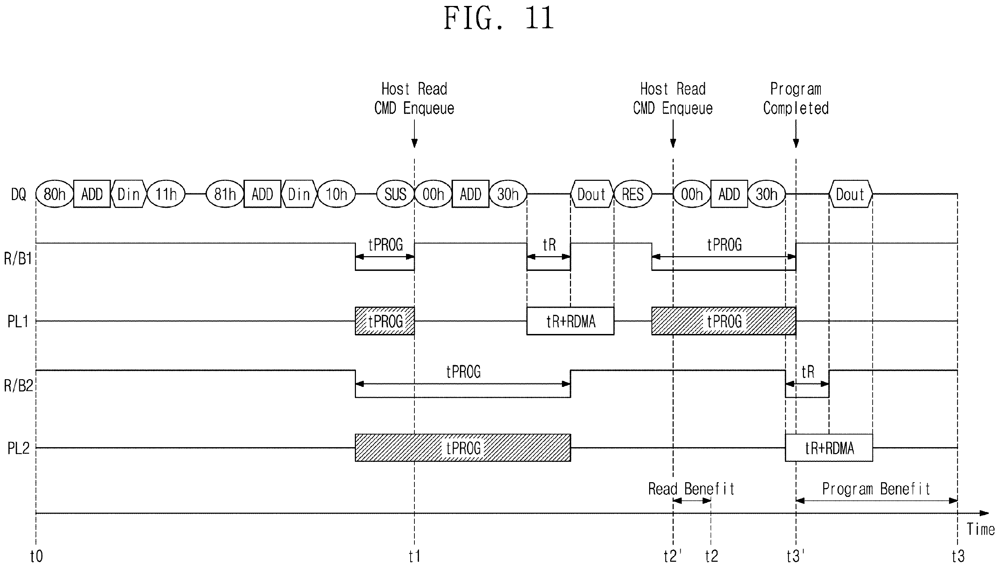

FIG. 11 is a timing diagram illustrating another example of a write operation and a read operation described with reference to FIGS. 8 and 9 in detail. In this case, write operations can be suspended independently for each plane.

The data signal DQ, the first ready/busy signal R/B1, the second ready/busy signal R/B2, and time values of operations which are performed in the first plane PL1 and the second plane PL2 are illustrated in FIG. 11. For convenience of description, it is assumed that the nonvolatile memory NVM11 (refer to FIG. 4) includes the first plane PL1 and the second plane PL2. In this case, based on the storage device 1000, the peripheral circuit 1211 may output the first ready/busy signal R/B1 corresponding to the first plane PL1 and may output the second ready/busy signal R/B2 corresponding to the second plane PL2.

Referring to FIGS. 1, 4, and 11 together, at a time point t0, the storage controller 1100 may sequentially transfer commands, addresses, and data associated with the multi-plane write operation to the nonvolatile memory NVM11.

First, the storage controller 1100 activates the chip enable signal CE and transfers the first command 80h, the address ADD, the write data Din, and the second command 11h to the nonvolatile memory NVM11 through the data signal DQ. Afterwards, the storage controller 1100 transfers the third command 81h, the address ADD, the write data Din, and the fourth command 10h to the nonvolatile memory NVM11 through the data signal DQ.

In some implementations, the first command 80h is a command indicating a start of a page program for the first plane PL1 of the nonvolatile memory NVM11, the address ADD is an address indicating a physical location where the write data Din will be stored, and the second command 11h is a command which forms a set with the first command 80h and indicates an end of the transfer of a signal necessary for the page program for the first plane PL1 of the nonvolatile memory NVM11.

In some implementations, the third command 81h is a command indicating a start of a page program for the second plane PL2 of the nonvolatile memory NVM11, the address ADD is an address indicating a physical location where the write data Din will be stored, and the fourth command 10h is a command which forms a set with the third command 81h and indicates an end of the transfer of a signal necessary for the page program for the second plane PL2 of the nonvolatile memory NVM11.

When the fourth command 10h for the second plane PL2 is transferred to the nonvolatile memory NVM11, the write operation on the first plane PL1 and the write operation on the second plane PL2 may be performed during the program time tPROG.

Meanwhile, when the read request is enqueued to the input/output scheduler according to the read request from the host device 100 while the write operations are performed on the first plane PL1 and the second plane PL2, the program operation on a plane (e.g., PL1), in which the read operation will be performed, from among the first plane PL1 and the second plane PL2 of the nonvolatile memory NVM11 should be suspended. Afterwards, the storage controller 1100 generates the suspend command SUS and transfers the suspend command SUS to the nonvolatile memory NVM11. At a time point t1, the nonvolatile memory NVM11 may temporarily suspend the write operation on the first plane PL1 in response to the suspend command SUS. Unlike the example of FIG. 10, the suspend command SUS is applied only to the first plane PL1, and the write operation on the second plane PL2 is not suspended.

When the write operation on the first plane PL1 is suspended by the suspend command SUS, the nonvolatile memory NVM11 may transfer, to the storage controller 1100, the first ready/busy signal R/B1 indicating that the first plane PL1 is in the ready state. In response to the first ready/busy signal R/B1, the storage controller 1100 transfers, to the nonvolatile memory NVM11, the first command 00h associated with the read operation, the address ADD, and the second command 30h associated with the read operation.

In some implementations, the first command 00h associated with the read operation is a command indicating a start of a page read, the address ADD is an address indicating a physical address where the read data Dout are stored, and the second command 30h associated with the read operation is a command which forms a set with the first command 00h and indicates an end of the transfer of a signal necessary for the page read. When the second command 30h associated with the read operation is transferred to the nonvolatile memory NVM11, the read operation on the first plane PL1 may be performed during a time "tR + RDMA".

When the read operation on the first plane PL1 is completed, the nonvolatile memory NVM11 may transfer, to the storage controller 1100, the first ready/busy signal R/B1 indicating that the first plane PL1 is in the ready state. The storage controller 1100 generates the resume command RES for resuming the suspended write operation in response to the first ready/busy signal R/B1 and transfers the resume command RES to the nonvolatile memory NVM11. In response to the resume command RES, the write operation on the first plane PL1 in the nonvolatile memory NVM1 1 may be resumed. The resumed write operation on the first plane PL1 may be performed during tPROG after the nonvolatile memory NVM11 receives the resume command RES and may be terminated at a time point t3'.

Meanwhile, the write operation on the second plane PL2 may be completed regardless of receiving the suspend command SUS for the first plane PL1. After the write operation on the second plane PL2 is completed, when the read request for the second plane PL2 is received from the host device 100, the storage controller 1100 may perform the read operation on the second plane PL2 without suspending the write operation being performed on the first plane PL1. That is, at a time point t2', the storage controller 1100 may transfer the command set 00h and 30h and the address ADD for performing the read operation on the second plane PL2 to the nonvolatile memory NVM11, and the read operation on the second plane PL2 may be performed during "tR + RDMA".

In some implementations, 80h and 10h are used as a command set associated with the write operation, and 00h and 30h are used as a command set associated with the read operation. However, these numbers and characters constituting a command set are provided as an example, and the present disclosure is not limited thereto.

Comparing the example of FIG. 11 and the example described with reference to FIG. 10, it may be understood that, by using a suspend command and a resume command that are capable of independently controlling respective planes, the program time of the nonvolatile memory NVM11 may be shortened as much as (t3 - t3'), and the read time of the nonvolatile memory NVM11 may be shortened as much as (t2 - t2').

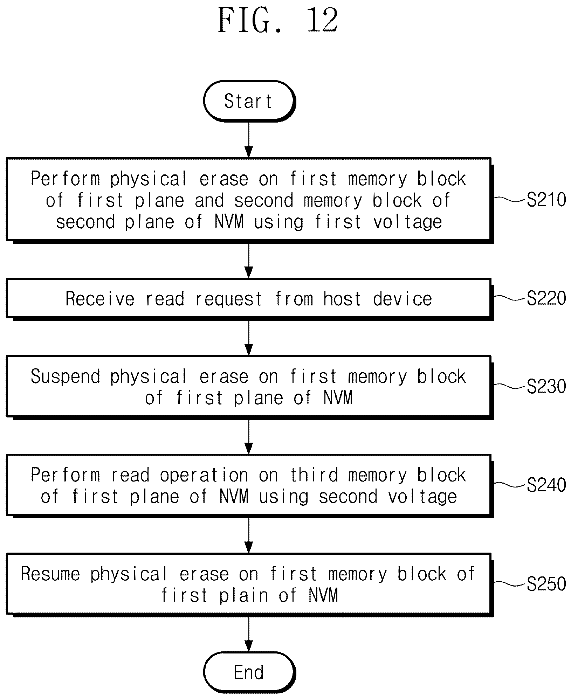

FIG. 12 is a flowchart illustrating an example of an operating method of a storage device. Referring to FIGS. 1, 4, and 12, in operation S210, physical erase on a first memory block of the first plane PL1 of the nonvolatile memory NVM11 and a second memory block of the second plane PL2 of the nonvolatile memory NVM11 may be performed. For example, the physical erase may be performed in the process of performing garbage collection for securing a programmable storage space by removing invalid pages of a memory block. The storage controller 1100 may use a first voltage to perform the physical erase operation. For example, the first voltage may mean an erase voltage and may be generated by the voltage generator of the peripheral circuit 1211.

In operation S220, the storage controller 1100 may receive the read request from the host device 100. The storage controller 1100 may generate the read command and an address for reading data from the nonvolatile memory device 1200 in response to the read request. For example, the read operation may be associated with a memory block, which does not experience the physical erase, from among the memory blocks of the first plane PL1 and the second plane PL2.

In operation S230, the storage controller 1100 may temporarily suspend the physical erase operation on a plane (e.g., PL1), which includes a memory block where the read operation will be performed by the read command, from among the planes PL1 and PL2 in which the physical erase operations are being performed. In some implementations, when in state in which the physical erase operation being performed on the first plane PL1 or the second plane PL2 is to be temporarily suspended as the read command is input to the input/output scheduler, the storage controller 1100 may generate the suspend command. The suspend command may support a suspend operation which is independent for each plane.

In operation S240, the storage controller 1100 may perform the read operations on the first plane PL1 of the nonvolatile memory NVM11 based on the read command. For example, the read operation may be performed on a memory block (e.g., the third memory block BLK3), which does not experience the erase operation, from among the memory blocks of the first plane PL1. The storage controller 1100 may use a second voltage to perform the read operation. For example, the second voltage may be a read voltage.

Meanwhile, because the physical erase operation is still being performed on the second plane PL2 while the read operation is being performed on the first plane PL1, the first plane PL1 and the second plane PL2 may operate based on different voltages. For example, the first plane PL1 may be provided with the second voltage (e.g., the read voltage) used for the read operation, and the second plane PL2 may be provided with the first voltage (e.g., the erase voltage) used for the physical erase operation. To simultaneously generate voltages of different levels, the voltage generator of the peripheral circuit 1211 may include a charge pump and a voltage regulator or may include a plurality of charge pumps.

In operation S250, when the read operation on the first plane PL1 ends, the storage controller 1100 may resume the physical erase operation on the first plane PL1. As discussed above, the suspend command may support a suspend operation which is independent for each plane.

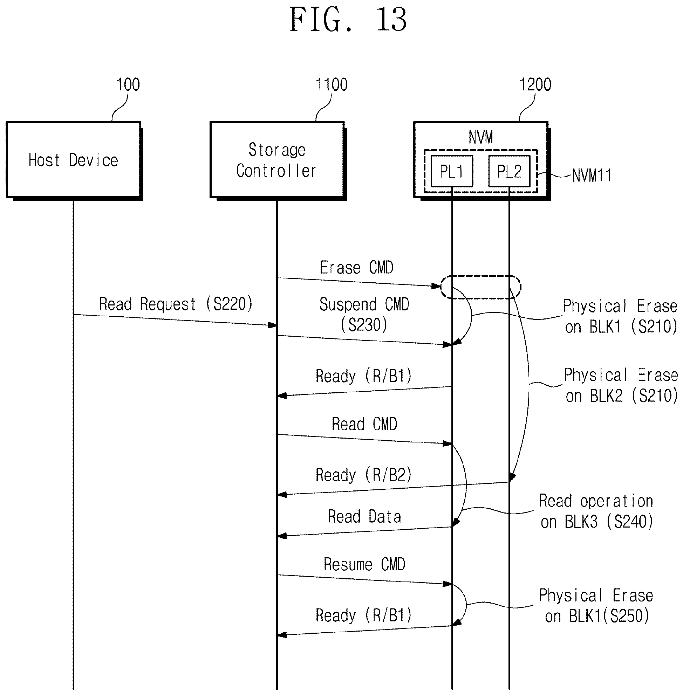

FIG. 13 is a diagram for describing an operating method of a storage device, e.g., the storage device described with reference to FIG. 12.

Referring to FIGS. 12 and 13, the flash translation layer of the storage controller 1100 may perform the physical erase operation on some blocks of a nonvolatile memory device in the process of performing garbage collection. The storage controller 1100 may transfer, to the nonvolatile memory device 1200, an erase command and an address of a memory block where the physical erase operation will be performed, and the nonvolatile memory NVM11 may perform the physical erase operation on the first memory block BLK1 of the first plane PL1 and the physical erase operation on the second memory block BLK2 of the second plane PL2 (S210).

While the physical erase operations on the first memory block BLK1 of the first plane PL1 and the second memory block BLK2 of the second plane PL2 are performed in the nonvolatile memory NVM11, the host device 100 may transfer the read request to the storage controller 1100 according to the request of the user (S220). The storage controller 1100 may generate the read command based on the read request, and the input/output scheduler may schedule the physical erase operation being already performed and the read operation to be performed, depending on a given policy.

When in a state in which the physical erase operation being performed on the first memory block BLK1 of the first plane PL1 is to be temporarily suspended as the read command is input to the input/output scheduler, the storage controller 1100 may generate the suspend command for suspending the operation being performed on the first plane PL1. In response to the suspend command, the physical erase operation being performed on the first memory block BLK1 of the first plane PL1 of the nonvolatile memory NVM11 may be temporarily suspended (S230). The nonvolatile memory NVM11 may deactivate the first ready/busy signal R/B1 to provide notification that the first plane PL1 is in a state where it is possible to perform an operation. Erasing on the second memory block BLK2 may continue.

The storage controller 1100 may transfer the read command and the address to the nonvolatile memory NVM11 in response to the first ready/busy signal R/B1 thus deactivated. The nonvolatile memory NVM11 may perform the read operation on the third memory block BLK3 of the first plane PL1 in response to the read command and the address (S240). Data read from the first plane PL1 as a result of the read operation may be transferred to the host device 100 through the storage controller 1100. The storage controller 1100 may generate the resume command for the first plane PL1 and may transfer the resume command to the nonvolatile memory NVM11. In response to the resume command, the nonvolatile memory NVM11 may resume the physical erase operation on the first memory block BLK1 of the first plane PL1 (S250).

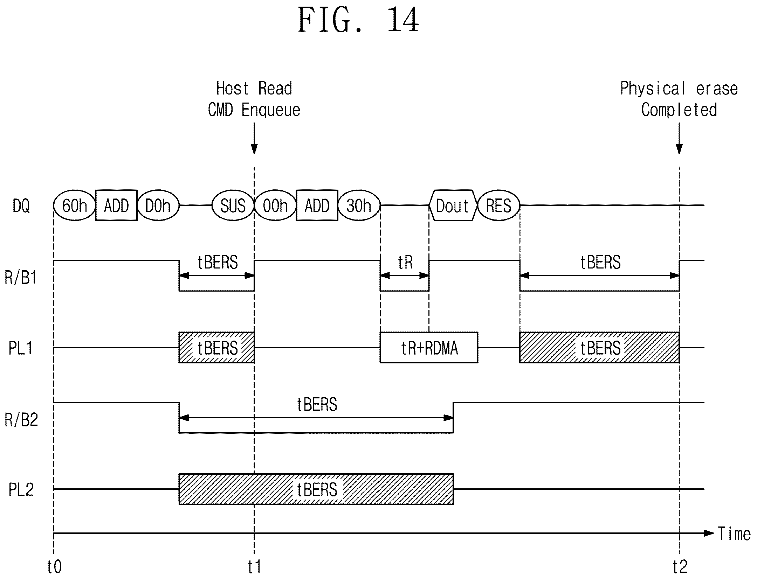

FIG. 14 is a timing diagram illustrating a physical erase operation and a read operation described with reference to FIGS. 8 and 13 in detail.

The data signal DQ, the first ready/busy signal R/B1, the second ready/busy signal R/B2, and time values of operations which are performed in the first plane PL1 and the second plane PL2 are illustrated in FIG. 14. Assuming that the nonvolatile memory NVM11 (refer to FIG. 4) includes the first plane PL1 and the second plane PL2, the peripheral circuit 1211 may output the first ready/busy signal R/B1 corresponding to the first plane PL1 and may output the second ready/busy signal R/B2 corresponding to the second plane PL2.

Referring to FIGS. 1, 4, and 14 together, at a time point t0, the storage controller 1100 sequentially transfers a first command 60h associated with the multi-plane erase operation, an address ADD, and a second command D0h associated with the multi-plane erase operation to the nonvolatile memory NVM11. The storage controller 1100 activates the chip enable signal CE and transfers the first command 60h associated with the erase operation, the address ADD, and the second command D0h associated with the erase operation to the nonvolatile memory NVM11 through the data signal DQ.

In some implementations, the first command 60h associated with the erase operation is a command indicating a start of memory block erase, the address ADD is an address indicating a physical address where the erase operation is performed, and the second command D0h associated with the erase operation is a command which forms a set with the first command 60h and indicates an end of the transfer of a signal necessary for the memory block erase. When the second command D0h associated with the erase operation is transferred to the nonvolatile memory NVM11, the erase operation on the first memory block BLK1 of the first plane PL1 and the erase operation on the second memory block BLK2 of the second plane PL2 may be performed during an erase time tBERS.

Meanwhile, when the read command is enqueued to the input/output scheduler according to the read request from the host device 100 while the erase operations are performed on the first memory block BLK1 of the first plane PL1 and the second memory block BLK2 of the second plane PL2, the erase operation on a plane (e.g., PL1), in which the read operation will be performed, from among the first plane PL1 and the second plane PL2 of the nonvolatile memory NVM11 should be suspended. Afterwards, the storage controller 1100 generates the suspend command SUS and transfers the suspend command SUS to the nonvolatile memory NVM11. At a time point t1, the nonvolatile memory NVM11 may temporarily suspend the erase operation on the first plane PL1 in response to the suspend command SUS.

When the erase operation on the first memory block BLK1 of the first plane PL1 is suspended by the suspend command SUS, the nonvolatile memory NVM11 may transfer, to the storage controller 1100, the first ready/busy signal R/B1 indicating that the first plane PL1 is in the ready state. In response to the first ready/busy signal R/B1, the storage controller 1100 transfers, to the nonvolatile memory NVM11, the first command 00h associated with the read operation, the address ADD, and the second command 30h associated with the read operation. When the second command 30h associated with the read operation is transferred to the nonvolatile memory NVM11, the read operation on the first plane PL1 may be performed during a time "tR + RDMA".

When the read operation on the first plane PL1 is completed, the nonvolatile memory NVM11 may transfer, to the storage controller 1100, the first ready/busy signal R/B1 indicating that the first plane PL1 is in the ready state. The storage controller 1100 generates the resume command RES for resuming the suspended erase operation in response to the first ready/busy signal R/B1 and transfers the resume command RES to the nonvolatile memory NVM11. In response to the resume command RES, the erase operation on the first memory block BLK1 of the first plane PL1 in the nonvolatile memory NVM11 may be resumed. The resumed erase operation on the first plane PL1 may be performed during tBERS after the nonvolatile memory NVM11 receives the resume command RES and may be terminated at a time point t2.

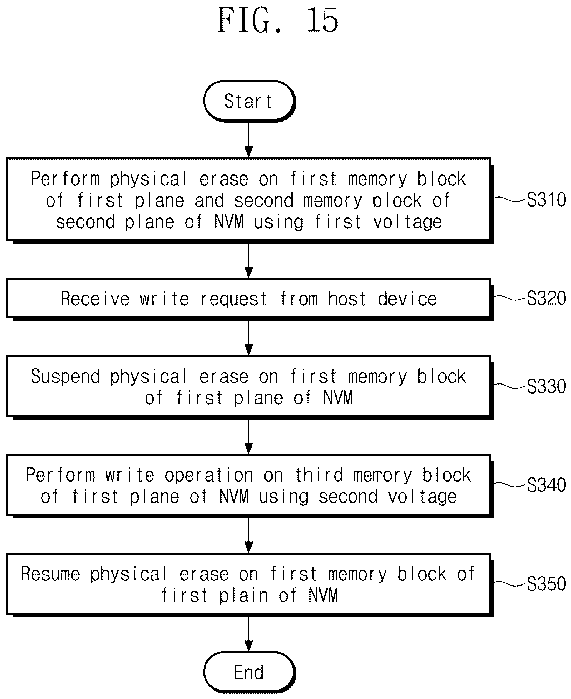

FIG. 15 is a flowchart illustrating an example of an operating method of a storage device. FIG. 15 is associated with an operating method corresponding to a case where the write request is received while the physical erase is performed on the first memory block BLK1 of the first plane PL1 and the second memory block BLK2 of the second plane PL2. That is, the example of FIG. 15 is mostly similar to the example of FIG. 12, and thus, some description will be omitted to avoid redundancy or will be briefly described.

Referring to FIGS. 1, 4, and 15, in operation S310, physical erase on the first memory block BLK1 of the first plane PL1 of the nonvolatile memory NVM11 and the second memory block BLK2 of the second plane PL2 of the nonvolatile memory NVM11 may be performed.

In operation S320, the storage controller 1100 may receive the write request from the host device 100. The storage controller 1100 may generate the write command and an address for programming data in the nonvolatile memory device 1200 in response to the write request. For example, the write operation may be associated with a memory block (e.g., the third memory block BLK3), which does not experience the physical erase, from among the memory blocks of the first plane PL1 and the second plane PL2.

In operation S330, the storage controller 1100 may temporarily suspend the physical erase operation on a plane (e.g., PL1), which includes a memory block where the write operation will be performed, from among the planes PL1 and PL2. The physical erase operation on plane PL2 may continue, e.g., may not be suspended.

In operation S340, the storage controller 1100 may perform the write operation on the first plane PL1 of the nonvolatile memory NVM11 based on the write command. For example, the write operation may be performed on a memory block (e.g., the third memory block BLK3), which does not experience the erase operation, from among the memory blocks of the first plane PL1. The storage controller 1100 may use a second voltage to perform the write operation. For example, the second voltage may be a write voltage.

Meanwhile, because the physical erase operation is still being performed on the second plane PL2 while the write operation is being performed on the first plane PL1, the first plane PL1 and the second plane PL2 may operate based on different voltages. For example, the first plane PL1 may be provided with the second voltage (e.g., the write voltage) used for the write operation, and the second plane PL2 may be provided with the first voltage (e.g., the erase voltage) used for the physical erase operation.

In operation S350, when the write operation on the first plane PL1 ends, the storage controller 1100 may resume the physical erase operation on the first plane PL1. The suspend command of the present disclosure may support the suspend operation which is independent for each plane.

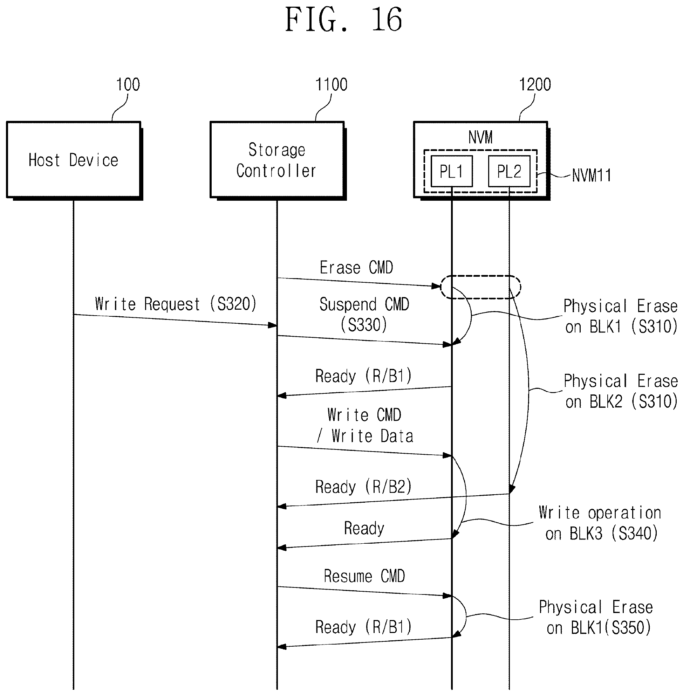

FIG. 16 is a diagram for describing an operating method of a storage device described with reference to FIG. 15.

Referring to FIGS. 15 and 16, a physical erase on the first memory block BLK1 of the first plane PL1 of the nonvolatile memory NVM11 and the second memory block BLK2 of the second plane PL2 of the nonvolatile memory NVM11 may be performed in the process of performing garbage collection (S310).

During the physical erase operations on the first plane PL1 and the second plane PL2 of the nonvolatile memory NVM11, the host device 100 may transfer the write request to the storage controller 1100 according to the request of the user (S320). The storage controller 1100 may generate the write command based on the write request, and the input/output scheduler may schedule the physical erase operation being already performed and the write operation to be soon performed. The storage controller 1100 may generate the suspend command for suspending the operation being performed on the first plane PL1. The physical erase operation being performed on the first memory block BLK1 of the first plane PL1 of the nonvolatile memory NVM11 may be temporarily suspended in response to the suspend command (S330), and the nonvolatile memory NVM11 may deactivate the first ready/busy signal R/B1 to provide notification that the first plane PL1 is in a state where it is possible to perform an operation.

The storage controller 1100 may transfer the write command, write data, and an address to the nonvolatile memory NVM11 in response to the first ready/busy signal R/B1 thus deactivated. The nonvolatile memory NVM11 may perform the write operation on the third memory block BLK3 of the first plane PL1 (S340). When the write operation is completed, the nonvolatile memory NVM11 may deactivate the first ready/busy signal R/B1 to provide notification that the first plane PL1 is in a state where it is possible to perform an operation.

The storage controller 1100 may generate the resume command for the first plane PL1 and may transfer the resume command to the nonvolatile memory NVM11. In response to the resume command, the nonvolatile memory NVM11 may resume the physical erase operation on the first memory block BLK1 of the first plane PL1 (S350).

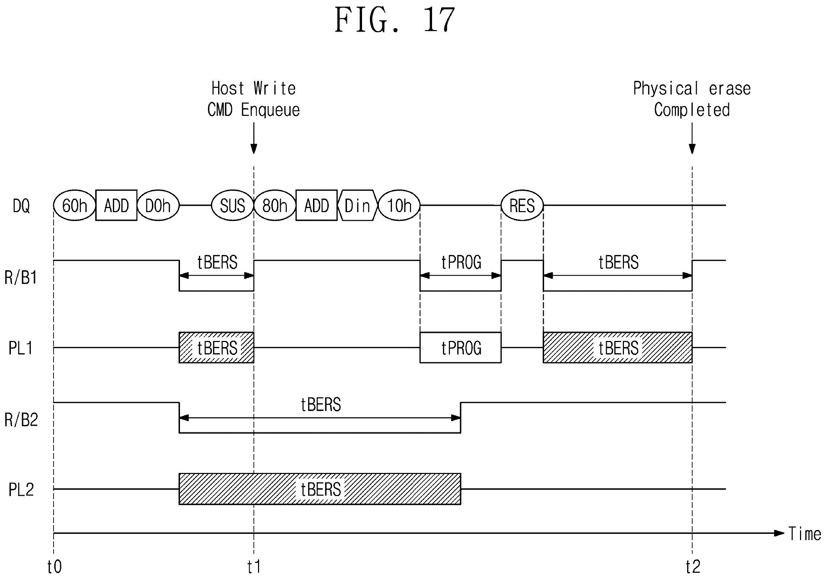

FIG. 17 is a timing diagram illustrating a physical erase operation and a write operation described with reference to FIGS. 15 and 16 in detail.

The timing diagram of FIG. 17 is mostly similar to the timing diagram of FIG. 14 associated with the erase operation and the read operation. Thus, some description will be omitted to omitted redundancy.

During the physical erase on the first plane PL1 and the second plane PL2 of the nonvolatile memory NVM11, the physical erase operation on the first plane PL1 may be temporarily suspended by the suspend command SUS according to the write request of the user. However, because the suspend command SUS of the present disclosure is a plane-independent command, there may be no influence on the second plane PL2, and the physical erase operation on the second plane PL2 will continue.

When the erase operation on the first plane PL1 is suspended, the storage controller 1100 may transfer the command set 80h and 10h, the write data Din, and the address ADD for the write operation to the nonvolatile memory NVM11, and the write operation on the first plane PL1 may be started. For example, the write operation may continue during tPROG and may be performed on a memory block not associated with the erase operation from among the memory blocks of the first plane PL1.

When the write operation on the first plane PL1 ends, the storage controller 1100 may transfer the resume command RES for resuming the suspended erase operation to the first plane PL1, and because the resume command RES is plane-independent, there may be no influence on the second plane PL2. Afterwards, the erase operation on the first plane PL1 may be resumed, and at a time point t2, the erase operation on the first plane PL1 may be completed.

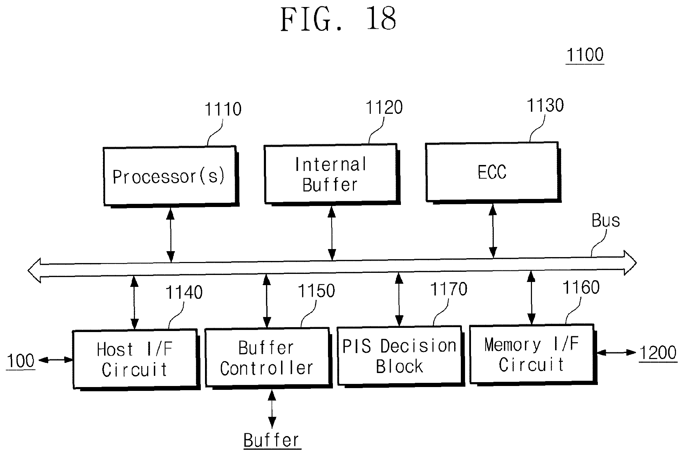

FIG. 18 illustrates an example of a configuration of a storage controller, e.g., the storage controller of FIG. 1. Because a configuration of the storage controller 1100 of FIG. 18 is mostly similar to the configuration of the storage controller 1100 of FIG. 3, some description will be omitted to avoid redundancy.

The storage controller 1100 includes at least one processor 1110, the internal buffer 1120, the error check and correction (ECC) engine 1130, the host interface circuit 1140, the buffer controller 1150, the memory interface circuit 1160, and a PIS decision block 1170.

When a command for a second operation is received while a first operation is performed on one nonvolatile memory, the PIS decision block 1170 may decide whether to issue a plane-independent suspend command of the present disclosure. In some implementations, when the number of planes to be temporarily suspended from among planes of the nonvolatile memory is smaller than or equal to a reference value, the PIS decision block 1170 may issue the plane-independent suspend command. In contrast, when the number of planes to be temporarily suspended from among the planes of the nonvolatile memory exceeds the reference value, the PIS decision block 1170 may issue a suspend command which is applied all the planes. That is, according to some implementations of the present disclosure, both plane-wise suspend commands and all-plane suspend commands can be issued, depending on the scenario.

The PIS decision block 1170 may be implemented in the form of dedicated hardware, software, firmware, or a combination thereof. In some implementations, when the PIS decision block 1170 is implemented by software or firmware, the PIS decision block 1170 may be stored in the nonvolatile memory device 1200 (refer to FIG. 1), and may be implemented to be loaded and executed onto the internal buffer 1120.

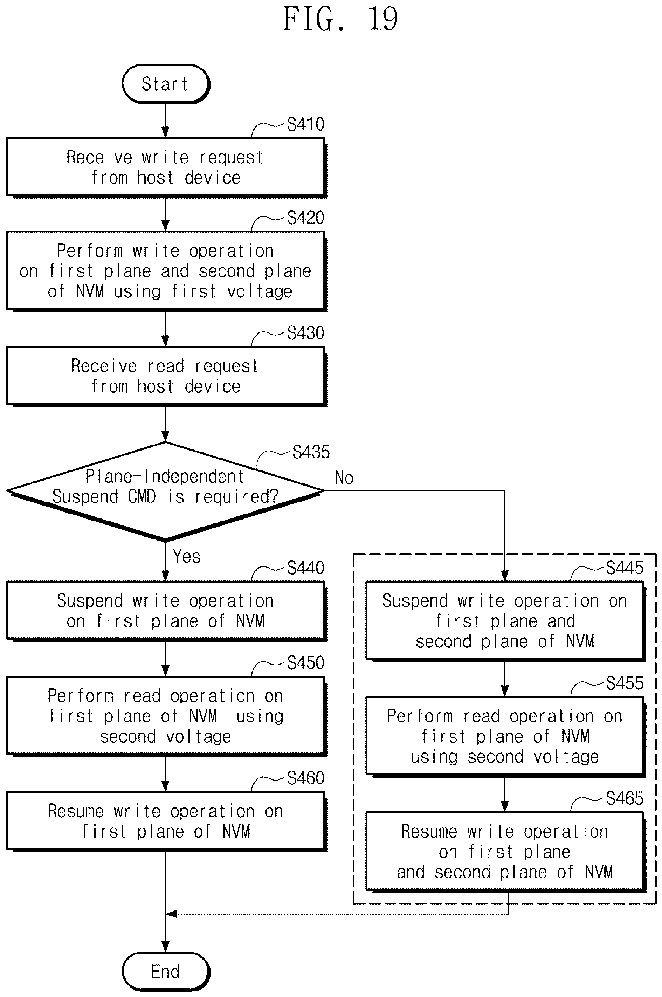

FIG. 19 is a flowchart illustrating an example of an operating method of a storage device.

Referring to FIGS. 4, 18, and 19 together, in operation S410, the storage controller 1100 may receive the write request from the host device 100. The storage controller 1100 may generate the program command for storing data in the nonvolatile memory device 1200 in response to the write request.

In operation S420, the storage controller 1100 may simultaneously perform the write operations on the first plane PL1 and the second plane PL2 of the nonvolatile memory NVM11 based on the program command and the write data. The storage controller 1100 may use a first voltage to perform the write operation. For example, the first voltage may be a program voltage. In addition to the program voltage, the storage controller 1100 may further use a verify voltage to perform the write operation. In some implementations, the voltage generator of the peripheral circuit 1211 may generate the program voltage, the verify voltage, etc. for performing the program operation.

In operation S430, the storage controller 1100 may receive the read request from the host device 100. The storage controller 1100 may generate the read command for reading data from the nonvolatile memory device 1200 in response to the read request.

In operation S435, the PIS decision block 1170 of the storage controller 1100 may determine whether to perform the plane-independent suspend command. For example, when the number of planes to be temporarily suspended from among planes of a nonvolatile memory is smaller than or equal to the reference value, the plane-independent suspend command may be selected (Yes).

When the plane-independent suspend command is selected, in operation S440, the storage controller 1100 may issue the plane-independent suspend command. The nonvolatile memory NVM11 may temporarily suspend the write operation on the first plane PL1 in response to the plane-independent suspend command.

In operation S450, the storage controller 1100 may perform the read operation on the first plane PL1 of the nonvolatile memory NVM11 based on the read command. The storage controller 1100 may use a second voltage to perform the read operation. For example, the second voltage may be a read voltage. Of course, because the write operation is still being performed on the second plane PL2 while the read operation is being performed on the first plane PL1, the write operation using the first voltage (i.e., the program voltage) may be still being performed on the second plane PL2.

In operation S460, when the read operation on the first plane PL1 ends, the storage controller 1100 may resume the write operation on the first plane PL1.

Meanwhile, in operation S435, when it is determined that the number of planes to be temporarily suspended from among planes of a nonvolatile memory is greater than the reference value (No), that is, when it is determined not to perform the plane-independent suspend command (No), operation S445 may be executed.

In operation S445, the storage controller 1100 may issue the suspend command to be applied to all planes of the nonvolatile memory, and the nonvolatile memory NVM11 may temporarily suspend the write operations on all the planes of the nonvolatile memory NVM11.

In operation S455, the storage controller 1100 may perform the read operation on the first plane PL1 of the nonvolatile memory NVM11 by using the second voltage. In this case, because the operation on the second plane PL2 is temporarily suspended by the suspend command, the second plane PL2 may not perform any operation.

When the read operation on the first plane PL1 is completed, in operation S465, the storage controller 1100 may generate the resume command, and the write operations on the first plane PL1 and the second plane PL2 of the nonvolatile memory NVM11 may be resumed in response to the resume command.

In reference to FIG. 19, it was described how to process a read request received while write operations on the planes of the nonvolatile memory are being performed. However, one skilled in the art will understand that the description provided for FIG. 19 may equally be applied to the examples of FIGS. 12 and 15, e.g., in the case of processing a read request received while erase operations are being perform or receiving a write request while erase operations are being performed.

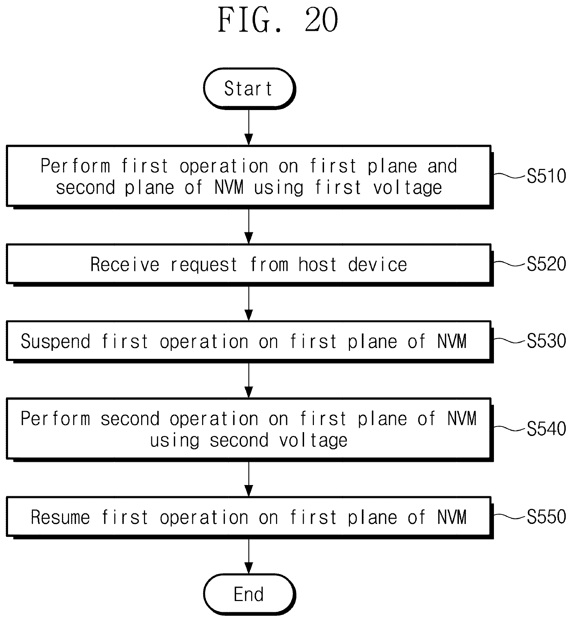

FIG. 20 is a flowchart illustrating an example of an operating method of a storage device.

Referring to FIGS. 1, 4, and 20, in operation S510, the storage controller 1100 may perform a first operation on the first plane PL1 and the second plane PL2 of the nonvolatile memory NVM11 by using a first voltage. For example, the first operation may be an operation corresponding to a command according to a request of the user. As another example, the first operation may be an operation corresponding to a command used to manage the storage device 1000, not a command according to the request of the user. For example, the first operation may include the write operation, the read operation, the erase operation, etc., but the present disclosure is not limited thereto.

In operation S520, the storage controller 1100 may receive a request from the host device 100. The request in operation S520 may be different from the request mentioned in operation S510.

In operation S530, the storage controller 1100 may generate the plane-independent suspend command for temporarily suspending a first request for the first plane PL1 of the nonvolatile memory NVM11. In response to the plane-independent suspend command, the first operation being performed on the first plane PL1 of the nonvolatile memory NVM11 may be temporarily suspended.

In operation S540, the storage controller 1100 may generate a command corresponding to the user request received in operation S520 and may perform a second operation on the first plane PL1 of the nonvolatile memory NVM11 by using the command and a second voltage. For example, the second operation which is different from the first operation may include the write operation, the read operation, the erase operation, etc., but the present disclosure is not limited thereto. Specifically, when the first operation is a read operation, the second operation may be a write or an erase operation, when the first operation is a write operation, the second operation may be a read operation or an erase operation, and when the first operation is an erase operation, the second operation may be a read operation or a write operation.

When the second operation on the first plane PL1 is completed, in operation S550, the storage controller 1100 may generate the plane-independent suspend command. In response to the plane-independent suspend command, the storage controller 1100 may resume the first operation suspended on the first plane PL1.

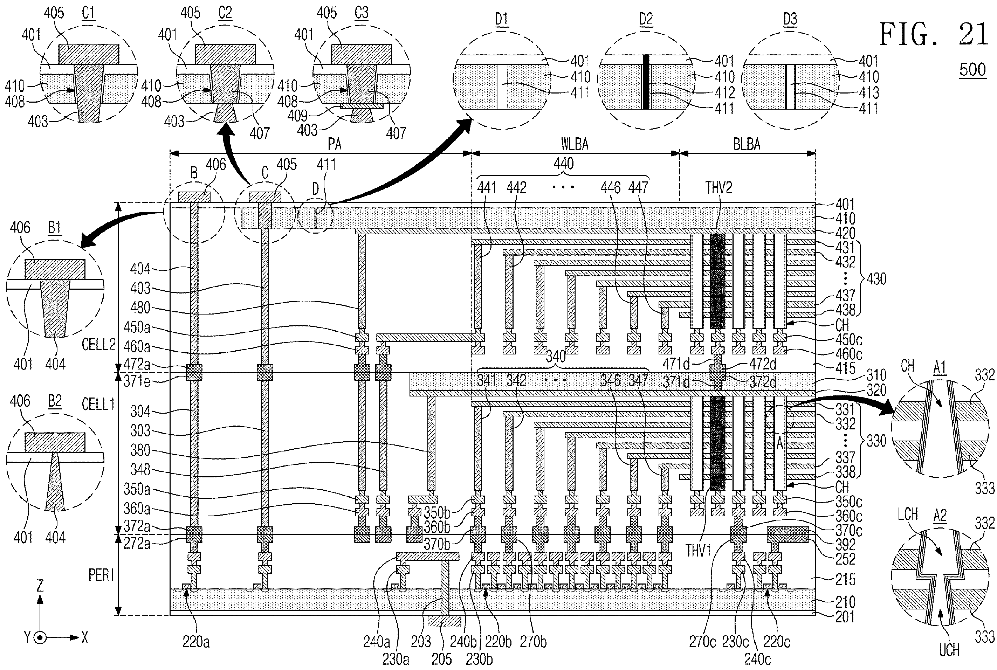

FIG. 21 is a view illustrating an example of a memory device 500. The memory device 500 can be included in any of the NVMs described herein.

Referring to FIG. 21, the memory device 500 may have a chip-to-chip (C2C) structure. Herein, in the C2C structure, after fabricating at least one upper chip including a cell region CELL and at least one lower chip including a peripheral circuit region PERI, respectively, the upper chip and the lower chip may be bonded to each other by a bonding method. As an example, the bonding method may mean a method of electrically or physically connecting a bonding metal pattern formed in the uppermost metal layer of the upper chip and a bonding metal pattern formed in the uppermost metal layer of the lower chip. For example, when the bonding metal patterns are formed of copper (Cu), the bonding method may be referred to as a "Cu-Cu bonding method". As another example, the bonding metal patterns may also be formed of aluminum (Al) or tungsten (W).

The memory device 500 may include at least one upper chip including a cell region. For example, as illustrated in FIG. 21, the memory device 500 may be implemented to include two upper chips. However, this is illustrative, and the number of upper chips is not limited thereto. In the case in which the memory device 500 is implemented to include two upper chips, the memory device 500 may be manufactured by separately manufacturing a first upper chip including a first cell region CELL1, a second upper chip including a second cell region CELL2, and a lower chip including the peripheral circuit region PERI and thereafter connecting the first upper chip, the second upper chip, and the lower chip by a bonding method. The first upper chip may be turned over and connected to the lower chip by the bonding method, and the second upper chip may also be turned over and connected to the first upper chip by the bonding method. In the following description, upper portions and lower portions of the first and second upper chips are defined based on before the first upper chip and the second upper chip are turned over. That is, in FIG. 21, an upper portion of the lower chip refers to an upper portion defined based on a +Z-axis direction, and the upper portions of the first and second upper chips refer to upper portions defined based on a - Z-axis direction. However, this is illustrative, and only one of the first upper chip and the second upper chip may be turned over and connected by the bonding method.

Each of the peripheral circuit region PERI and the first and second cell regions CELL1 and CELL2 of the memory device 500 may include an external pad bonding region PA, a word line bonding region WLBA, and a bit line bonding region BLBA.

The peripheral circuit region PERI may include a first substrate 210 and a plurality of circuit elements 220a, 220b, and 220c formed on the first substrate 210. An interlayer insulating layer 215 including one or more insulating layers may be provided on the plurality of circuit elements 220a, 220b, and 220c, and a plurality of metal lines connecting the plurality of circuit elements 220a, 220b, and 220c may be provided in the interlayer insulating layer 215. For example, the plurality of metal lines may include first metal lines 230a, 230b, and 230c connected with the plurality of circuit elements 220a, 220b, and 220c, respectively, and second metal lines 240a, 240b, and 240c formed on the first metal lines 230a, 230b, and 230c. The plurality of metal lines may be formed of at least one of various conductive materials. For example, the first metal lines 230a, 230b, and 230c may be formed of tungsten having a relatively high electrical resistivity, and the second metal lines 240a, 240b, and 240c may be formed of copper having a relatively low electrical resistivity.

In this specification, only the first metal lines 230a, 230b, and 230c and the second metal lines 240a, 240b, and 240c are illustrated and described. However, without being limited thereto, one or more additional metal lines may be further formed on the second metal lines 240a, 240b, and 240c. In this case, the second metal lines 240a, 240b, and 240c may be formed of aluminum At least some of the additional metal lines formed on the second metal lines 240a, 240b, and 240c may be formed of copper having a lower electrical resistivity than the aluminum of the second metal lines 240a, 240b, and 240c.

The interlayer insulating layer 115 may be disposed on the first substrate 210 and may include an insulating material, such as silicon oxide or silicon nitride.

Each of the first and second cell regions CELL1 and CELL2 may include at least one memory block. The first cell region CELL1 may include a second substrate 310 and a common source line 320. A plurality of word lines 330 (331 to 338) may be stacked on the second substrate 310 in a direction (i.e., the Z-axis direction) perpendicular to an upper surface of the second substrate 310. String selection lines and a ground selection line may be disposed on and under the word lines 330, and the plurality of word lines 330 may be disposed between the string selection lines and the ground selection line. Likewise, the second cell region CELL2 may include a third substrate 410 and a common source line 420, and a plurality of word lines 430 (431 to 438) may be stacked in a direction (i.e., the Z-axis direction) perpendicular to an upper surface of the third substrate 410. The second substrate 310 and the third substrate 410 may be formed of various materials and may be, for example, silicon substrates, silicon-germanium substrates, germanium substrates, or substrates having mono-crystalline epitaxial layers grown on mono-crystalline silicon substrates. A plurality of channel structures CH may be formed in the first and second cell regions CELL1 and CELL2.

In some implementations, as illustrated in A1, the channel structure CH may be provided in the bit line bonding region BLBA and may extend in the direction perpendicular to the upper surface of the second substrate 310 to penetrate the word lines 330, the string selection lines, and the ground selection line. The channel structure CH may include a data storage layer, a channel layer, and a buried insulating layer. The channel layer may be electrically connected with a first metal line 350c and a second metal line 360c in the bit line bonding region BLBA. For example, the second metal line 360c may be a bit line and may be connected to the channel structure CH through the first metal line 350c. The bit line 360c may extend in a first direction (a Y-axis direction) parallel to the upper surface of the second substrate 310.

In some implementations, as illustrated in A2, the channel structure CH may include a lower channel LCH and an upper channel UCH connected to each other. For example, the channel structure CH may be formed through a process for the lower channel LCH and a process for the upper channel UCH. The lower channel LCH may extend in the direction perpendicular to the upper surface of the second substrate 310 and may penetrate the common source line 320 and the lower word lines 331 and 332. The lower channel LCH may include a data storage layer, a channel layer, and a buried insulating layer and may be connected with the upper channel UCH. The upper channel UCH may penetrate the upper word lines 333 to 338. The upper channel UCH may include a data storage layer, a channel layer, and a buried insulating layer, and the channel layer of the upper channel UCH may be electrically connected with the first metal line 350c and the second metal line 360c. As the length of a channel is increased, it may be difficult to form a channel having a constant width due to process reasons. The memory device 500 may include a channel having improved width uniformity through the lower channel LCH and the upper channel UCH formed by sequential processes.

In the case in which the channel structure CH includes the lower channel LCH and the upper channel UCH as illustrated in A2, a word line located near the boundary between the lower channel LCH and the upper channel UCH may be a dummy word line. For example, the word line 332 and the word line 333 that form the boundary between the lower channel LCH and the upper channel UCH may be dummy word lines. In this case, data may not be stored in memory cells connected to the dummy word lines. Alternatively, the number of pages corresponding to the memory cells connected to the dummy word lines may be smaller than the number of pages corresponding to memory cells connected to normal word lines. A voltage level applied to the dummy word lines may differ from a voltage level applied to the normal word lines, and thus an influence of a non-uniform channel width between the lower channel LCH and the upper channel UCH on an operation of the memory device may be reduced.

Meanwhile, it is illustrated in A2 that the number of lower word lines 331 and 332 penetrated by the lower channel LCH is smaller than the number of upper word lines 333 to 338 penetrated by the upper channel UCH. However, this is illustrative, and the present disclosure is not limited thereto. In another example, the number of lower word lines penetrated by the lower channel LCH may be equal to or larger than the number of upper word lines penetrated by the upper channel UCH. Furthermore, the above-described structure and connection relationship of the channel structure CH disposed in the first cell region CELL1 may be identically applied to the channel structure CH disposed in the second cell region CELL2.

In the bit line bonding region BLBA, a first through-electrode THV1 may be provided in the first cell region CELL1, and a second through-electrode THV2 may be provided in the second cell region CELL2. As illustrated in FIG. 21, the first through-electrode THV1 may penetrate the common source line 320 and the plurality of word lines 330. However, this is illustrative, and the first through-electrode THV1 may additionally penetrate the second substrate 310. The first through-electrode THV1 may include a conductive material. Alternatively, the first through-electrode THV1 may include a conductive material surrounded by an insulating material. The second through-electrode THV2 may have the same shape and structure as the first through-electrode THV1.

In some implementations, the first through-electrode THV1 and the second through-electrode THV2 may be electrically connected through a first through-metal pattern 372d and a second through-metal pattern 472d. The first through-metal pattern 372d may be formed on a lower side of the first upper chip including the first cell region CELL1, and the second through-metal pattern 472d may be formed on an upper side of the second upper chip including the second cell region CELL2. The first through-electrode THV1 may be electrically connected with the first metal line 350c and the second metal line 360c. A lower VIA 371d may be formed between the first through-electrode THV1 and the first through-metal pattern 372d, and an upper VIA 471d may be formed between the second through-electrode THV2 and the second through-metal pattern 472d. The first through-metal pattern 372d and the second through-metal pattern 472d may be connected by a bonding method.

Furthermore, in the bit line bonding region BLBA, an upper metal pattern 252 may be formed on the uppermost metal layer of the peripheral circuit region PERI, and an upper metal pattern 392 having the same shape as the upper metal pattern 252 may be formed on the uppermost metal layer of the first cell region CELL1. The upper metal pattern 392 of the first cell region CELL1 and the upper metal pattern 252 of the peripheral circuit region PERI may be electrically connected to each other by a bonding method. In the bit line bonding region BLBA, the bit line 360c may be electrically connected with a page buffer included in the peripheral circuit region PERI. For example, some of the circuit elements 220c of the peripheral circuit region PERI may provide a page buffer, and the bit line 360c may be electrically connected with the circuit elements 220c providing the page buffer through an upper bonding metal 370c of the first cell region CELL1 and an upper bonding metal 270c of the peripheral circuit region PERI.

Continuing to refer to FIG. 21, in the word line bonding region WLBA, the word lines 330 of the first cell region CELL1 may extend in a second direction (an X-axis direction) parallel to the upper surface of the second substrate 310 and may be connected with a plurality of cell contact plugs 340 (341 to 347). A first metal line 350b and a second metal line 360b may be sequentially connected to upper portions of the cell contact plugs 340 connected to the word lines 330. In the word line bonding region WLBA, the cell contact plugs 340 may be connected with the peripheral circuit region PERI through an upper bonding metal 370b of the first cell region CELL1 and an upper bonding metal 270b of the peripheral circuit region PERI.

The cell contact plugs 340 may be electrically connected with a row decoder included in the peripheral circuit region PERI. For example, some of the circuit elements 220b of the peripheral circuit region PERI may provide a row decoder, and the cell contact plugs 340 may be electrically connected with the circuit elements 220b providing the row decoder through the upper bonding metal 370b of the first cell region CELL1 and the upper bonding metal 270b of the peripheral circuit region PERI. In some implementations, an operating voltage of the circuit elements 220b that provide the row decoder may differ from an operating voltage of the circuit elements 220c that provide the page buffer. For example, the operating voltage of the circuit elements 220c that provide the page buffer may be greater than the operating voltage of the circuit elements 220b that provide the row decoder.

Likewise, in the word line bonding region WLBA, the word lines 430 of the second cell region CELL2 may extend in the second direction (i.e., the X-axis direction) parallel to the upper surface of the third substrate 410 and may be connected with a plurality of cell contact plugs 440 (441 to 447). The cell contact plugs 440 may be connected with the peripheral circuit region PERI through an upper metal pattern of the second cell region CELL2, a lower metal pattern and an upper metal pattern of the first cell region CELL1, and a cell contact plug 348.

In the word line bonding region WLBA, the upper bonding metal 370b may be formed in the first cell region CELL1, and the upper bonding metal 270b may be formed in the peripheral circuit region PERI. The upper bonding metal 370b of the first cell region CELL1 and the upper bonding metal 270b of the peripheral circuit region PERI may be electrically connected to each other by a bonding method. The upper bonding metal 370b and the upper bonding metal 270b may be formed of aluminum, copper, or tungsten.

In the external pad bonding region PA, a lower metal pattern 371e may be formed on a lower portion of the first cell region CELL1, and an upper metal pattern 472a may be formed on an upper portion of the second cell region CELL2. The lower metal pattern 371e of the first cell region CELL1 and the upper metal pattern 472a of the second cell region CELL2 may be connected by a bonding method in the external pad bonding region PA. Likewise, an upper metal pattern 372a may be formed on an upper portion of the first cell region CELL1, and an upper metal pattern 272a may be formed on an upper portion of the peripheral circuit region PERI. The upper metal pattern 372a of the first cell region CELL1 and the upper metal pattern 272a of the peripheral circuit region PERI may be connected to each other by a bonding method.

Common source line contact plugs 380 and 480 may be disposed in the external pad bonding region PA. The common source line contact plugs 380 and 480 may be formed of a conductive material, such as metal, a metal compound, or doped poly-silicon. The common source line contact plug 380 of the first cell region CELL1 may be electrically connected with the common source line 320, and the common source line contact plug 480 of the second cell region CELL2 may be electrically connected with the common source line 420. A first metal line 350a and a second metal line 360a may be sequentially stacked on an upper portion of the common source line contact plug 380 of the first cell region CELL1, and a first metal line 450a and a second metal line 460a may be sequentially stacked on an upper portion of the common source line contact plug 480 of the second cell region CELL2.

Input/output pads 205, 405, and 406 may be disposed in the external pad bonding region PA. Referring to FIG. 21, a lower insulating layer 201 may cover a lower surface of the first substrate 210, and the first input/output pad 205 may be formed on the lower insulating layer 201. The first input/output pad 205 may be connected with at least one of the plurality of circuit elements 220a disposed in the peripheral circuit region PERI through a first input/output contact plug 203 and may be separated from the first substrate 210 by the lower insulating layer 201. In addition, a side insulating layer may be disposed between the first input/output contact plug 203 and the first substrate 210 and may electrically isolate the first input/output contact plug 203 from the first substrate 210.

An upper insulating layer 401 may be formed on the third substrate 410 to cover the upper surface of the third substrate 410. The second input/output pad 405 and/or the third input/output pad 406 may be disposed on the upper insulating layer 401. The second input/output pad 405 may be connected with at least one of the plurality of circuit elements 220a disposed in the peripheral circuit region PERI through second input/output contact plugs 403 and 303, and the third input/output pad 406 may be connected with at least one of the plurality of circuit elements 220a disposed in the peripheral circuit region PERI through third input/output contact plugs 404 and 304.

In some implementations, the third substrate 410 may not be disposed in the regions in which the input/output contact plugs are disposed. For example, as illustrated in B, the third input/output contact plug 404 may be separated from the third substrate 410 in a direction parallel to the upper surface of the third substrate 410, may penetrate an interlayer insulating layer 415 of the second cell region CELL2, and may be connected to the third input/output pad 406. In this case, the third input/output contact plug 404 may be formed through various processes.

For example, as illustrated in B1, the third input/output contact plug 404 may extend in the third direction (i.e., the Z-axis direction) and may have an increasing diameter toward the upper insulating layer 401. That is, while the channel structure CH described with reference to A1 has a decreasing diameter toward the upper insulating layer 401, the third input/output contact plug 404 may have an increasing diameter toward the upper insulating layer 401. For example, the third input/output contact plug 404 may be formed after the second cell region CELL2 and the first cell region CELL1 are coupled by a bonding method.

For example, as illustrated in B2, the third input/output contact plug 404 may extend in the third direction (i.e., the Z-axis direction) and may have a decreasing diameter toward the upper insulating layer 401. That is, likewise to the channel structure CH, the third input/output contact plug 404 may have a decreasing diameter toward the upper insulating layer 401. For example, the second input/output contact plug 403 may be formed together with the cell contact plugs 440 before the second cell region CELL2 and the first cell region CELL1 are coupled by a bonding method.

In some implementations, an input/output contact plug may be disposed to overlap the third substrate 410. For example, as illustrated in C, the second input/output contact plug 403 may be formed through the interlayer insulating layer 415 of the second cell region CELL2 in the third direction (i.e., the Z-axis direction) and may be electrically connected to the second input/output pad 405 through the third substrate 410. In this case, a connection structure of the second input/output contact plug 403 and the second input/output pad 405 may be implemented in various ways.

For example, as illustrated in C1, an opening 408 may be formed through the third substrate 410, and the second input/output contact plug 403 may be directly connected to the second input/output pad 405 through the opening 408 formed in the third substrate 410. In this case, as illustrated in C1, the second input/output contact plug 403 may have an increasing diameter toward the second input/output pad 405. However, this is illustrative, and the second input/output contact plug 403 may have a decreasing diameter toward the second input/output pad 405.

For example, as illustrated in C2, the opening 408 may be formed through the third substrate 410, and a contact 407 may be formed in the opening 408. One end portion of the contact 407 may be connected to the second input/output pad 405, and an opposite end portion of the contact 407 may be connected to the second input/output contact plug 403. Accordingly, the second input/output contact plug 403 may be electrically connected to the second input/output pad 405 through the contact 407 in the opening 408. In this case, as illustrated in C2, the contact 407 may have an increasing diameter toward the second input/output pad 405, and the second input/output contact plug 403 may have a decreasing diameter toward the second input/output pad 405. For example, the third input/output contact plug 404 may be formed together with the cell contact plugs 440 before the second cell region CELL2 and the first cell region CELL1 are coupled by a bonding method, and the contact 407 may be formed after the second cell region CELL2 and the first cell region CELL1 are coupled by the bonding method.

For example, as illustrated in C3, a stopper 409 may be additionally formed on an upper surface of the opening 408 of the third substrate 410. The stopper 409 may be a metal line formed on the same layer as the common source line 420. However, this is illustrative, and the stopper 409 may be a metal line formed on the same layer as at least one of the word lines 430. The second input/output contact plug 403 may be electrically connected to the second input/output pad 405 through the contact 407 and the stopper 409.

Meanwhile, similarly to the second and third input/output contact plugs 403 and 404 of the second cell region CELL2, the second and third input/output contact plugs 303 and 304 of the first cell region CELL1 may have a decreasing diameter toward the lower metal pattern 371e, or may have an increasing diameter toward the lower metal pattern 371e.

Meanwhile, in some implementations, a slit 411 may be formed in the third substrate 410. For example, the slit 411 may be formed at any position in the external pad bonding region PA. For example, as illustrated in D, the slit 411 may be located between the second input/output pad 405 and the cell contact plugs 440 when viewed on a plane. However, this is illustrative, and the slit 411 may be formed such that the second input/output pad 405 is located between the slit 411 and the cell contact plugs 440 when viewed on the plane.

For example, as illustrated in D1, the slit 411 may be formed through the third substrate 410. For example, the slit 411 may be used to prevent the third substrate 410 from being finely cracked when the opening 408 is formed. However, this is illustrative, and the slit 411 may be formed to have a depth ranging from about 60% to about 70% of the thickness of the third substrate 410.

For example, as illustrated in D2, a conductive material 412 may be formed in the slit 411. For example, the conductive material 412 may be used to discharge a leakage current generated while circuit elements in the external pad bonding region PA are driven. In this case, the conductive material 412 may be connected to an external ground line.

For example, as illustrated in D3, an insulating material 413 may be formed in the slit 411. For example, the insulating material 413 may be formed to electrically isolate the second input/output pad 405 and the second input/output contact plug 403 disposed in the external pad bonding region PA from the word line bonding region WLBA. An influence of a voltage provided through the second input/output pad 405 on a metal layer disposed on the third substrate 410 in the word line bonding region WLBA may be interrupted by forming the insulating material 413 in the slit 411.

Meanwhile, in some implementations, the first to third input/output pads 205, 405, and 406 may be selectively formed. For example, the memory device 500 may be implemented to include only the first input/output pad 205 disposed on the lower insulating layer 201, only the second input/output pad 405 disposed on the third substrate 410, or only the third input/output pad 406 disposed on the upper insulating layer 401.

Meanwhile, in some implementations, at least one of the second substrate 310 of the first cell region CELL1 or the third substrate 410 of the second cell region CELL2 may be used as a sacrificial substrate and may be completely or partially removed before or after a bonding process. An additional layer may be stacked after the removal of the substrate. For example, the second substrate 310 of the first cell region CELL1 may be removed before or after the peripheral circuit region PERI and the first cell region CELL1 are bonded to each other, and an insulating layer for covering an upper surface of the common source line 320 or a conductive layer for connection may be formed. Similarly, the third substrate 410 of the second cell region CELL2 may be removed before or after the first cell region CELL1 and the second cell region CELL2 are bonded to each other, and the upper insulating layer 401 for covering an upper surface of the common source line 420 or a conductive layer for connection may be formed.

According to some implementations of the present disclosure, operations being performed on planes constituting a nonvolatile memory may be individually suspended by supporting a plane-independent suspend command.

According to some implementations of the present disclosure, the operations suspended on the planes constituting a nonvolatile memory may be individually resumed by supporting the plane-independent suspend command.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While the present disclosure has been described with reference to examples thereof, it will be apparent to those of ordinary skill in the art that various changes and modifications may be made thereto without departing from the scope of the present disclosure as set forth in the following claims.

## Claims

1. A storage device (1000) comprising:
a nonvolatile memory device (1200) including a nonvolatile memory (NVM11), wherein the nonvolatile memory (NVM11) includes a plurality of planes (PL1, PL2); and
a storage controller (1100) configured to control the nonvolatile memory device (1200), wherein the storage controller (1100) is configured to:
perform a write operation on each of a first plane (PL1) and a second plane (PL2) of the plurality of planes in response to a write request from a host device (100); and
generate a suspend command configured to temporarily suspend the write operation on the first plane (PL1) in response to a read request from the host device (100) while the write operation on the first plane (PL1) and the second plane (PL2) are performed.

2. The storage device (1000) of claim 1, wherein the nonvolatile memory device (1200) is configured to temporarily suspend the write operation on the first plane (PL1) based on the suspend command, and wherein the storage controller (1100) is configured to perform a read operation, corresponding to the read request, on the first plane (PL1) while the write operation is performed on the second plane (PL2).

3. The storage device (1000) of claim 2, wherein the storage controller (1100) is configured to generate, based on completion of the read operation on the first plane (PL1), a resume command for resuming the write operation on the first plane (PL1), and wherein the nonvolatile memory device (1200) is configured to resume the write operation on the first plane (PL1) based on the resume command.

4. The storage device (1000) of claim 1, 2, or 3 comprising a voltage generator (1261a; 1261b) configured to simultaneously generate a write voltage for performing the write operation on the first and second planes (PL1, PL2) and a read voltage for performing the read operation.

5. The storage device (1000) of any one of claims 1 to 4, wherein the nonvolatile memory device (1200) is configured to output a first ready/busy signal corresponding to the first plane (PL1) and a second ready/busy signal corresponding to the second plane (PL2).

6. The storage device (1000) of claim 5, wherein the nonvolatile memory device (1200) is configured to output the first ready/busy signal as an activated signal while the write operation on the first plane (PL1) is suspended by the suspend command, and wherein the nonvolatile memory device (1200) is configured to output the second ready/busy signal as a deactivated signal while the write operation on the second plane (PL2) is performed.

7. The storage device (1000) of any one of claims 1 to 6, wherein, when the number of planes, in which a read operation according to the read request is to be performed, from among the plurality of planes is less than or equal to a reference value, the storage controller (1100) generates the suspend command for temporarily suspending the write operation on the planes in which the read operation is to be performed.

8. The storage device (1000) of any one of claims 1 to 6, wherein the suspend command is a first suspend command, wherein, when the number of planes, in which a read operation according to the read request is to be performed, from among the plurality of planes exceeds a reference value, the storage controller (1100) is configured to generates a second suspend command for temporarily suspending the write operation on the plurality of planes (PL1, PL2).

9. The storage device (1000) of any one of claims 1 to 8, wherein the nonvolatile memory device (1200) includes a page buffer circuit (1230) including a first page buffer (PB1) corresponding to the first plane (PL1) and a second page buffer (PB2) corresponding to the second plane (PL2).

10. The storage device (1000) of any one of claims 1 to 9, wherein the nonvolatile memory device (1200) includes a memory cell array (1210) including a plurality of cell strings (CS) arranged in a vertical direction on a substrate (SUB), and wherein each of the plurality of cell strings (CS) includes at least one string selection transistor (SST), a plurality of memory cells (MC) connected in series, and at least one ground selection transistor (GST).

11. A method of operating a storage device (1000), wherein the storage device (1000) includes, a nonvolatile memory device (1200) including a nonvolatile memory (NVM11), wherein the nonvolatile memory (NVM11) includes a plurality of planes (PL1, PL2), and a storage controller (1100) configured to control the nonvolatile memory device (1200), wherein the method comprises:
performing a first operation on a first plane (PL1) and a second plane (PL2) of the plurality of planes (PL1, PL2);
receiving a request from a host device (100);
generating, based on the request, a suspend command configured to temporarily suspend the first operation on the first plane (PL1) while the first operation on the first plane (PL1) and the first operation on the second plane (PL2) are performed; and
temporarily suspending the first operation on the first plane (PL1) based on the suspend command.

12. The method of claim 11, further comprising:
activating and outputting a first ready/busy signal corresponding to the first plane (PL1) while the first operation on the first plane (PL1) is temporarily suspended by the suspend command; and
deactivating and outputting a second ready/busy signal corresponding to the second plane (PL2) while the first operation is performed on the second plane (PL2).

13. The method of claim 11 or 12, further comprising, performing a second operation corresponding to the request on the first plane (PL1).

14. The method of claim 13, further comprising, generating a resume command for resuming the first operation on the first plane (PL1) in based on completion of the second operation on the first plane (PL1); and resuming the first operation on the first plane (PL1) based on the resume command.

15. The method of claim 13 or 14, further comprising, generating a first voltage for performing the first operation on the first and second planes (PL1, PL2); and generating a second voltage for performing the second operation.
